# FASCICULE DE BREVET EUROPEEN

(11) **EP 2 596 523 B1**
(45) Date de publication et mention de la délivrance du brevet: **31.12.2014**
(21) Numéro de dépôt: 11735627.9
(22) Date de dépôt: 13.07.2011
(51) Int. Cl.: H01L 21/335, H01L 29/06, H01L 29/41, H01L 29/08, H01L 29/45, H01L 29/775, B82Y 10/00, B82Y 40/00, H01L 21/32

(54) **DISPOSITIF ET PROCÉDÉ POUR FORMER SUR UN NANOFIL EN SEMI-CONDUCTEUR UN ALLIAGE DE CE SEMI-CONDUCTEUR AVEC UN MÉTAL OU UN MÉTALLOÏDE**
VORRICHTUNG UND VERFAHREN ZUR HERSTELLUNG AUF EINEM HALBLEITERNANODRAHT EINER LEGIERUNG DIESES HALBLEITERS MIT EINEM METALL ODER METALLOID
DEVICE AND PROCESS FOR FORMING, ON A NANOWIRE MADE OF A SEMICONDUCTOR, AN ALLOY OF THIS SEMICONDUCTOR WITH A METAL OR METALLOID

(30) Priorité: 19.07.2010 FR 1055847
(43) Date de publication de la demande: 29.05.2013
(73) Titulaire: Commissariat à l'Énergie Atomique et aux Énergies Alternatives, 75015 Paris (FR)
(72) Inventeur: MONGILLO, Massimo, F-38000 Grenoble (FR); DE FRANCESCHI, Silvano, F-38000 Grenoble (FR); SPATHIS, Panayotis, F-94110 Arcueil (FR)
(74) Mandataire: Ilgart, Jean-Christophe
(86) Numéro de dépôt international: PCT/EP2011/061924
(87) Numéro de publication internationale: WO 2012/010473

(56) Documents cités:
- EP-A1- 1 900 681
- WO-A1-2005/093831
- KR-B1- 100 844 094
- US-A1- 2008 246 020

## Description

### DOMAINE TECHNIQUE

L'invention a trait à un dispositif pour former sur des nanofils en semi-conducteur un alliage de ce semi-conducteur avec un métal ou un métalloïde.

L'invention a trait, en particulier, à un dispositif pour former des siliciures de métaux tels que le nickel sur des nanofils de silicium.

L'invention a également trait à un procédé pour former sur des nanofils en semi-conducteur un alliage de ce semi-conducteur avec un métal ou un metalloïde.

Le dispositif et le procédé selon l'invention permettent en particulier de former sur des nanofils en semi-conducteur des transistors avec des contacts métalliques, dont on peut contrôler la longueur du canal.

Le domaine technique de l'invention peut être défini de manière générale comme celui de la préparation de dispositifs à base de nanofils en semi-conducteur, par exemple en silicium, pourvus de contacts en alliage de ce semi-conducteur avec un métal ou un metalloïde, par exemple en siliciure de métal.

De tels nanofils trouvent leur application dans de nombreux dispositifs électroniques et optoélectroniques, notamment dans les transistors à effet de champ (« FET » ou « Field Effect Transistors » en langue anglaise) et plus particulièrement dans les transistors à effet de champ à structure métal-oxyde-semi-çonducteur (« MOSFET » ou « Metal Oxide Semiconductor Field Effect Transistor »).

### ÉTAT DE LA TECHNIQUE ANTÉRIEURE

Les nanofils de silicium préparés par le procédé de dépôt chimique en phase vapeur (« CVD » ou « Chemical Vapour Deposition » en langue anglaise) ont fait l'objet d'un intérêt considérable ces dernières années pour leur rôle futur en tant que blocs d'assemblages nanométriques pour des dispositifs fonctionnels tels que les transistors à effet de champ, les nanophotodétecteurs, les détecteurs, et les circuits logiques.

La « International Technology Roadmap for Semiconductor » (ITRS) prévoit que les nanofils de silicium remplaceront les "MOSFETs" classiques du fait de leur extensibilité et de leur densité d'intégration.

Un transistor à effet de champ classique est un dispositif à trois électrodes dans lequel le courant qui circule depuis la source vers le drain est commandé par le potentiel à l'électrode grille.

Les régions de source et de drain sont fortement dopées, avec un dopage qui est l'inverse de celui du substrat.

L'électrode grille est séparée du canal par une mince couche isolante. Lorsqu'une tension de polarisation suffisamment importante est appliquée à l'électrode grille, la surface du substrat est inversée pour former un canal conducteur avec une forte densité de porteurs, et en conséquence un courant commence à circuler entre l'électrode source et l'électrode drain.

Le schéma de procédé normal pour la fabrication d'un « MOSFET » nécessite un fort dopage des contacts de source et de drain pour permettre une injection efficace des porteurs dans le canal.

Le dopage est suivi par une activation des dopants à haute température pour faire en sorte que l'ionisation soit totale.

A l'heure actuelle, il existe un intérêt croissant pour remplacer la région fortement dopée des « MOSFETs » par des siliciures métalliques afin de diminuer les résistances parasites élevées associées aux contacts.

Le schéma de contact source/drain qui utilise des siliciures nécessite un faible apport thermique, présente de manière inhérente une faible résistance, et la jonction métal-canal est abrupte au niveau atomique ce qui a pour conséquence une meilleure extensibilité du dispositif.

La formation du contact en siliciure de métal est normalement réalisée en chauffant le métal en contact avec le semi-conducteur.

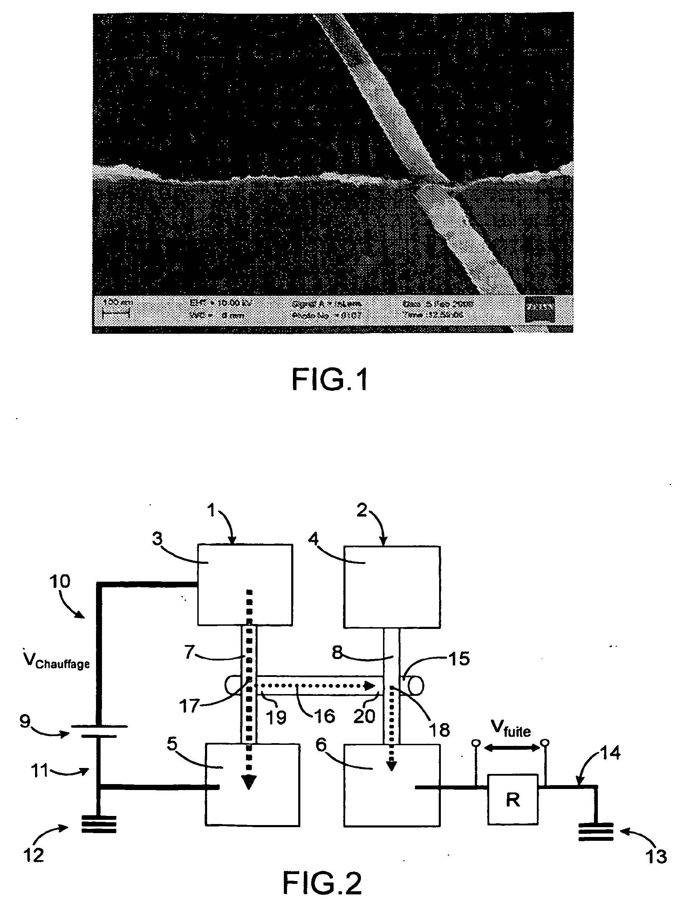

Sur la Figure 1, on montre un nanofil de silicium en contact avec une électrode en nickel. Après un recuit thermique dans un four à une température d'environ 500°C, on induit la pénétration du métal à l'intérieur du nanofil pour former ainsi une phase métallique de nickel et de silicium, c'est-à-dire un siliciure de métal. Cela est confirmé par l'observation de la Figure 1 où les régions plus brillantes du nanofil au voisinage du contact correspondent à la phase de siliciure de nickel.

Pour une température donnée, la longueur de la partie siliciée varie selon la quantité de métal qui recouvre le nanofil, le diamètre du nanofil et la durée du traitement de recuit.

Cependant, de manière inhérente, le traitement de recuit thermique réalisé dans un four n'est pas satisfaisant pour ce qui est du contrôle de la longueur de la partie siliciée, principalement à cause de la variation du diamètre du nanofil et de la qualité du film de métal déposé sur le nanofil.

Le document EP-A1-0 562 996 décrit un dispositif « antifuse » électriquement programmable qui comprend un substrat en silicium ; une jonction P-N formée dans ledit substrat en silicium ; des moyens isolants par exemple en silice, pour isoler électriquement et thermiquement la jonction P-N dans ledit substrat en silicium, la jonction P-N étant exposée au travers de ces moyens isolants, par exemple au moyen d'un trou prévu dans ces moyens isolants ; une couche métallique en contact avec la jonction P-N, qui réagit avec le silicium pour former des siliciures sur la jonction P-N. La couche métallique peut être en Ti, Cr, W, Mo ou Ta.

Dans ce document, le substrat en silicium est un substrat massif et non un substrat constitué par des nanofils de silicium.

Ce document concerne spécifiquement la préparation de dispositifs « antifuse », et ne concerne absolument pas la préparation de transistors à nanofils de silicium qui sont les dispositifs que l'on cherche plus particulièrement à préparer selon la présente invention.

Les documents US-2008/246020, EP-1.900.681 et KR-10-084 4094 montrent également des dispositifs à nanofil en silicium avec des contacts en siliciure de métaux.

Il existe donc au regard de ce qui précède un besoin non encore satisfait pour un dispositif et un procédé pour former sur des nanofils en semi-conducteur, par exemple en silicium, un alliage de ce semi-conducteur avec un métal ou un metalloïde, par exemple un siliciure de métal ou de metalloïde, qui permette de réguler, contrôler, de manière fiable, précise et reproductible la formation de cet alliage.

Il existe notamment un besoin pour un tel dispositif et un tel procédé qui permettent de contrôler de manière, fiable, précise et reproductible la longueur, et éventuellement la profondeur, de la partie du nanofil de semi-conducteur qui est transformée en alliage de ce semi-conducteur, par exemple en siliciure de métal ou de metalloïde.

Il existe plus précisément un besoin pour un tel dispositif et un tel procédé qui assurent un tel contrôle fiable et précis, quelles que soient les caractéristiques du métal ou du métalloïde (par exemple qualité, épaisseur d'un film de celui-ci) au contact du nanofil dans le but de former l'alliage, et quelles que soient les caractéristiques du nanofil, par exemple son diamètre.

Le but de l'invention est de fournir un dispositif et un procédé pour former sur des nanofils en semi-conducteur, par exemple en silicium, un alliage de ce semi-conducteur avec un métal ou un metalloïde, qui répondent entre autres aux besoins énumérés plus haut.

Le but de l'invention est encore de fournir un tel dispositif et un tel procédé qui ne présentent pas les inconvénients, défauts, limitations et désavantages des dispositifs et procédés de l'art antérieur et qui résolvent les problèmes des dispositifs et procédés de l'art antérieur.

### EXPOSÉ DE L'INVENTION

Ce but, et d'autres encore, sont atteints conformément à l'invention, par un dispositif configuré pour former sur un nanofil en un semi-conducteur, un alliage de ce semi-conducteur avec un métal ou un metalloïde, ledit dispositif comprenant :
- une première bande électriquement conductrice en un métal ou un métalloïde apte à former un alliage avec le semi-conducteur du nanofil, et une seconde bande électriquement conductrice en un métal ou un métalloïde apte à former un alliage avec le semi-conducteur du nanofil, espacées l'une de l'autre, la première et la seconde bandes électriquement conductrices, par exemple en nickel ou en platine, étant de préférence parallèles et formant une partie rétrécie respectivement d'une première ligne électriquement conductrice et d'une seconde ligne électriquement conductrice, lesdites première et seconde lignes électriquement conductrices comprenant chacune une première extrémité et une seconde extrémité, la partie centrale de la première bande électriquement conductrice étant apte à être mise en contact avec une première zone de la surface du nanofil et la partie centrale de la seconde bande électriquement conductrice étant apte à être mise en contact avec une deuxième zone de la surface du nanofil, espacée de la première zone dans le sens de la longueur du nanofil ;
- des moyens pour appliquer une différence de potentiel, entre la première extrémité de la première ligne électriquement conductrice et la seconde extrémité de la première ligne électriquement conductrice et faire passer un courant depuis la première extrémité vers la seconde extrémité de la première ligne électriquement conductrice pour provoquer un échauffement de la partie centrale de la première bande électriquement conductrice, et des moyens pour relier la seconde extrémité de la seconde ligne électriquement conductrice à la terre, lesdits moyens comprenant une résistance R ;
- éventuellement, des moyens pour appliquer une différence de potentiel, entre la première extrémité de la seconde ligne électriquement conductrice et la seconde extrémité de la seconde ligne électriquement conductrice lorsqu'aucune différence de potentiel n'est appliquée, entre la première extrémité de la première ligne électriquement conductrice et la seconde extrémité de la première ligne électriquement conductrice et faire passer un courant depuis la première extrémité vers la seconde extrémité de la seconde ligne. électriquement conductrice, et éventuellement des moyens pour relier la seconde extrémité de la première ligne électriquement conductrice à la terre, lesdits moyens comprenant une résistance R' ;
- des moyens pour mesurer une différence de potentiel, dite première différence de potentiel de fuite de part et d'autre de la résistance R ;
- éventuellement, des moyens pour mesurer une différence de potentiel, dite deuxième différence de potentiel de fuite de part et d'autre de la résistance R' ;
- des moyens pour appliquer une différence de potentiel, dite première différence de potentiel de polarisation entre la première zone de la surface du nanofil et la deuxième zone de la surface du nanofil, dans le sens de la longueur du nanofil ;
- éventuellement, des moyens pour appliquer une différence de potentiel, dite deuxième différence de potentiel de polarisation entre la deuxième zone de la surface du nanofil et la première zone de la surface du nanofil, dans le sens de la longueur du nanofil lorsque la première différence de potentiel de polarisation n'est pas appliquée.
Les première et seconde bandes conductrices peuvent aussi être désignées par la dénomination anglaise de « stripline ».

Par « partie rétrécie », on entend généralement que cette partie présente une section, généralement une section transversale, inférieure à la section moyenne du reste de la ligne électriquement conductrice.

Avantageusement, la première et la seconde bandes électriquement conductrices peuvent être parallèles.

Avantageusement, la première et la seconde bandes électriquement conductrices ont chacune une longueur de 1 à 5 µm, par exemple de 3 µm.

Avantageusement, la première et la seconde bandes électriquement conductrices sont espacées l'une de l'autre de 100 à 300 nm, par exemple de 200 nm à 300 nm, de préférence de 200 nm.

La première et la seconde bandes électriquement conductrices peuvent être en tout métal ou métalloïde apte à former des alliages avec le semi-conducteur qui compose le nanofil.

Avantageusement, la première et la seconde bandes électriquement conductrices peuvent être en nickel ou en platine.

Avantageusement, les moyens pour appliquer une différence de potentiel, entre la première extrémité de la première ligne électriquement conductrice et la seconde extrémité de la première ligne électriquement conductrice, et les moyens éventuels pour appliquer une différence de potentiel, entre la première extrémité de la seconde ligne électriquement conductrice et la seconde extrémité de la seconde ligne électriquement conductrice peuvent comporter des moyens pour augmenter ou diminuer cette (ces) différence(s) de potentiel de manière continue ou par incrément, de manière manuelle ou automatique, par exemple en fonction de la valeur mesurée de la première différence de potentiel de fuite, respectivement de la deuxième différence de potentiel de fuite.

Avantageusement, les moyens pour appliquer une différence de potentiel, entre la première extrémité de la première ligne électriquement conductrice et la seconde extrémité de la première ligne électriquement conductrice et les moyens pour appliquer une différence de potentiel, dite première différence de potentiel de polarisation entre la première zone de la surface du nanofil et la deuxième zone de la surface du nanofil, dans le sens de la longueur du nanofil sont constitués par un même premier générateur de tension.

Avantageusement, les moyens éventuels pour appliquer une différence de potentiel, entre la première extrémité de la seconde ligne électriquement conductrice et la seconde extrémité de la seconde ligne électriquement conductrice, et les moyens éventuels pour appliquer une différence de potentiel, dite deuxième différence de potentiel de polarisation entre la deuxième zone de la surface du nanofil et la première zone de la surface du nanofil, dans le sens de la longueur du nanofil sont constitués par un même deuxième générateur de tension.

Avantageusement, ledit premier et ledit deuxième générateurs de tension sont remplacés par un seul générateur de tension (sont constitués par un seul et même générateur) qui peut appliquer une différence de potentiel, entre la première extrémité de la première ligne électriquement conductrice et la seconde extrémité de la première ligne électriquement conductrice et une différence de potentiel, entre la première zone de la surface du nanofil et la deuxième zone de la surface du nanofil, dans le sens de la longueur du nanofil, ou bien qui peut appliquer une différence de potentiel, entre la première extrémité de la seconde ligne électriquement conductrice et la seconde extrémité de la seconde ligne électriquement conductrice, et une différence de potentiel, entre la deuxième zone de la surface du nanofil et la première zone de la surface du nanofil, dans le sens de la longueur du nanofil.

Avantageusement, la première ligne électriquement conductrice et la seconde ligne électriquement conductrice peuvent chacune comprendre plusieurs premières bandes électriquement conductrices et secondes bandes électriquement conductrices.

Il est ainsi possible de traiter simultanément plusieurs nanofils.

Si toutes les bandes électriquement conductrices formées le long d'une même ligne électriquement conductrice (par exemple la première ligne électriquement conductrice) et tous les nanofils à traiter ont la même résistivité alors il est possible d'appliquer une seule différence de potentiel entre la première extrémité de cette ligne électriquement conductrice et la seconde extrémité de cette ligne électriquement conductrice

Le dispositif selon l'invention n'a pas été décrit ou suggéré dans l'art antérieur.

Le dispositif selon l'invention répond à l'ensemble des besoins énumérés plus haut pour un tel dispositif et apporte une solution aux problèmes posés par les dispositifs de l'art antérieur.

Le dispositif selon l'invention permet notamment de contrôler avec précision, fiabilité, le courant de fuite et donc la formation de l'alliage de semi-conducteur, par exemple de siliciure de métal, et en particulier la longueur de la partie du nanofil de semi-conducteur, par exemple de silicium, transformée en alliage de métal, par exemple en siliciure de métal ou de métalloïde.

Le dispositif selon l'invention comprend en tant qu'éléments essentiels deux bandes électriquement conductrices (« striplines »).

Chacune de ces deux bandes électriquement conductrices a un rôle défini.

La première bande électriquement conductrice est utilisée pour former l'alliage de semi-conducteur et de métal ou de métalloïde, par exemple de siliciure de métal ou de métalloïde.

La première bande électriquement conductrice est reliée à des moyens qui permettent de faire passer un courant depuis sa première extrémité vers sa seconde extrémité.

La première bande électriquement conductrice forme un rétrécissement, une partie rétrécie, resserrée, ou constriction dans la première ligne électriquement conductrice. Cette partie rétrécie, restreint le passage du courant depuis la première extrémité de la première ligne conductrice vers la seconde extrémité de la première ligne électriquement conductrice. On pourrait aussi dire que cette partie rétrécie gêne, limite localement le passage de ce courant.

Du fait que l'intensité du courant reste la même lorsque le courant passe dans cette partie rétrécie, il en résulte une augmentation de la densité de courant dans cette partie rétrécie, ce qui cause localement, dans cette partie rétrécie, un échauffement par effet Joule de la bande.

En d'autres termes, la différence de potentiel appliquée chute principalement le long de cette partie rétrécie et, en conséquence, la température de la première ligne électriquement conductrice est plus élevée au niveau de cette partie retrécie.

L'échauffement de la première bande électriquement conductrice est en général maximum dans la partie centrale de la première bande électriquement conductrice, et, plus précisément encore, au milieu de celle-ci.

Autrement dit, le point le plus chaud de la première bande électriquement conductrice se situe dans la partie centrale, médiane de cette bande électriquement conductrice, et plus précisément encore au milieu de celle-ci.

Cette partie centrale de la première bande électriquement conductrice, est en un métal ou métalloïde, par exemple le nickel qui est apte à former un alliage avec le semi-conducteur du nanofil, et cette partie centrale est apte à être mise en contact avec une première zone de la surface d'un nanofil en semi-conducteur (par exemple en silicium) afin que se produise ainsi, lors de la mise en contact du nanofil et de la première bande électriquement conductrice, un chauffage local du contact et la formation d'un alliage du semi-conducteur et du métal ou métalloïde, par exemple la formation d'un siliciure de métal.

La seconde ligne électriquement conductrice (2) n'est pas, lors de la première étape du procédé selon l'invention, reliée à des moyens qui permettent de faire passer un courant depuis sa première extrémité vers sa seconde extrémité.

En effet lors de la première étape, il n'est pas nécessaire de relier la première (4) et la seconde extrémités (6) de la seconde ligne électriquement conductrice (2) à des générateurs externes fournissant un courant qui passe dans la ligne (2) (voir Figure 2).

Cette seconde ligne doit, lors de la première étape, seulement être reliée comme cela est montré sur la Figure 2, à la résistance R afin de pouvoir mesurer la différence de potentiel de fuite **(V_{fuite}).**

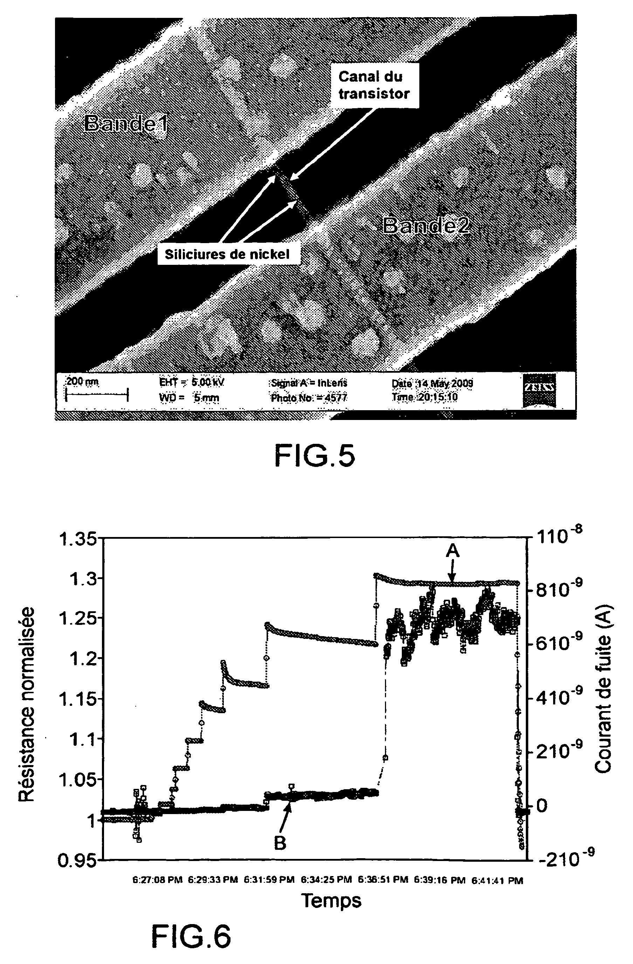

Lorsque ce potentiel de fuite a un saut, comme cela est montré sur la Figure 6, correspondant à un courant (courant de fuite) dans le nanofil de l'ordre de quelques nanoampères (dans le cas d'un nanofil non dopé), on sait alors que la formation de l'alliage par exemple de l'alliage de silicium (« siliciuration ») a eu lieu au niveau de la première zone de la surface du nanofil (premier contact).

Bien sûr, pour la préparation d'un transistor, le rôle des première (1) et seconde (2) lignes électriquement conductrices est ensuite inversé comme cela est expliqué plus loin, et alors la ligne (2) sera reliée à des générateurs externes qui permettent de faire passer un courant depuis sa première extrémité (4) vers sa seconde extrémité (6).

Lors de la première étape, la seconde extrémité (6) de la seconde ligne électriquement conductrice (2) est simplement reliée à la terre par des moyens qui comprennent une résistance en série (avec le nanofil lorsque celui-ci est présent) R ; des moyens étant prévus pour mesurer la différence de potentiel, dite première différence de potentiel de fuite de part et d'autre de la Résistance R.

La seconde bande électriquement conductrice et les moyens associés jouent donc alors un rôle de contrôle du courant de fuite, ce qui permet également, éventuellement de contrôler, commander ou réguler la pénétration du métal ou métalloïde dans le nanofil en semi-conducteur, par exemple en silicium et donc la longueur de la partie du nanofil transformée en alliage, par exemple en siliciure de métal.

L'invention concerne également un procédé pour former, sur au moins un nanofil en un semai-conducteur tel que le silicium, éventuellement dopé, un alliage de ce semi-conducteur avec un métal par exemple choisi parmi le nickel et le platine ou métalloïde, ledit nanofil ayant par exemple une longueur de 0,5 à 10 µm et un diamètre de 20 à 50 nm, dans lequel on réalise les étapes successives suivantes :
a) on dépose ledit au moins un nanofil en un semi-conducteur sur un substrat, par exemple une couche, en un matériau électriquement isolant, éventuellement disposé sur un autre substrat en un matériau différent dudit matériau électriquement isolant;
b) on met en contact une première zone de la surface du nanofil avec une partie centrale d'une première bande électriquement conductrice, en un métal ou un métalloïde apte à former un alliage avec le semi-conducteur du nanofil, formant une partie rétrécie entre une première extrémité et une seconde extrémité d'une première ligne électriquement conductrice, et on met en contact une deuxième zone de la surface du nanofil, espacée de la première zone dans le sens de la longueur du nanofil avec une partie centrale d'une seconde bande électriquement conductrice, en un métal ou un métalloïde apte à former un alliage avec le semi-conducteur du nanofil, formant une partie rétrécie entre une première extrémité et une seconde extrémité d'une seconde ligne électriquement conductrice ;
c) on applique une différence de potentiel dite première différence de potentiel de polarisation entre la première zone de la surface du nanofil et la deuxième zone de la surface du nanofil, dans le sens de la longueur du nanofil ;
d) on applique une différence de potentiel dite première différence de potentiel de chauffage, entre la première extrémité de la première ligne électriquement conductrice et la seconde extrémité de la première ligne électriquement conductrice, tout en maintenant constante la première différence de potentiel de polarisation, et on mesure simultanément une différence de potentiel, dite première différence de potentiel de fuite, de part et d'autre d'une résistance R en série avec le nanofil, située entre la seconde extrémité de la seconde ligne électriquement conductrice et la terre.
e) on augmente la première différence de potentiel de chauffage de manière continue ou par incrément, de manière manuelle ou automatique, généralement à partir d'une valeur voisine de zéro, jusqu'à ce que l'on observe un saut de la première différence de potentiel de fuite indiquant que la première différence de potentiel de chauffage est alors suffisante pour provoquer un échauffement de la partie centrale de la première bande électriquement conductrice et de la première zone de la surface du nanofil, la diffusion du métal ou du métalloïde dans et le long du nanofil, et la formation de l'alliage.

Avantageusement, le semi-conducteur peut être le silicium, éventuellement dopé.

Bien que le procédé selon l'invention n'ait été mis en oeuvre effectivement qu'avec des nanofils de silicium, l'homme du métier comprendra que le procédé selon l'invention peut également être mis en oeuvre avec succès avec d'autres semi-conducteurs.

En fait, pour former des alliages métalliques avec des semi-conducteurs, il est nécessaire d'utiliser des traitements thermiques, tels que le recuit thermique rapide (« Rapid Thermal Annealing » en langue anglaise) ou le recuit au four (« Furnace annealing » en langue anglaise). Avec le procédé de l'invention, il est possible de produire la chaleur requise par chauffage par effet Joule.

Le procédé selon l'invention peut être mis en oeuvre avec succès avec toutes sortes de nanofils quels que soient leurs diamètres ou tailles.

Avantageusement, les nanofils, peuvent avoir une longueur de 0,5 à 10 µm, de préférence de 1 à 10 µm, et un diamètre de 20 à 50 nm.

La nature chimique du substrat n'est pas importante, il doit seulement être isolant et résister aux fortes températures voisines par exemple d'environ 500°C dues au chauffage par effet Joule.

Avantageusement, le substrat en un matériau électriquement isolant est une couche en silice éventuellement disposée sur un substrat en silicium fortement dopé ; un substrat, par exemple une couche en nitrure de silicium ; ou un substrat, par exemple une couche d'alumine.

Avantageusement, on peut déposer plusieurs nanofils sur le substrat en un matériau électriquement isolant, lesdits nanofils étant disposés de manière aléatoire, leur position étant repérée à l'aide de marques préalablement réalisées sur le substrat; ou selon des structures, motifs ordonnés, par exemple sous la forme de rangées ordonnées de nanofils.

La première et la seconde bandes électriquement conductrices peuvent être en tout métal ou métalloïde apte à former des alliages avec des semi-conducteurs.

Avantageusement, la première et la seconde bandes électriquement conductrices peuvent être en nickel ou en platine.

Bien que le procédé selon l'invention n'ait été mis en oeuvre effectivement qu'avec le nickel et le platine, l'homme du métier comprendra que le procédé selon l'invention peut également être mis en oeuvre avec succès avec d'autres métaux ou métalloïdes aptes à former des alliages avec des semi-conducteurs.

Avantageusement, l'épaisseur de la couche du métal ou métalloïde doit être bien supérieure au diamètre du nanofil, par exemple une épaisseur de 80 à 120 nm est suffisante pour des nanofils de 20 nm de diamètre.

Avantageusement, en fonction de la première différence de potentiel de fuite mesurée, on modifie la première différence de potentiel de chauffage.

La différence de potentiel mesurée de part et d'autre de la résistance R, qui est appelée **V_{fuite}**, nous indique quel est le courant qui circule dans le nanofil pour une valeur donnée du courant qui passe dans la première bande électriquement conductrice (7) et de la différence de potentiel qui chute dans le nanofil entre les points (17) et (18) de la Figure 2.

A l'aide par exemple d'un amplificateur opérationnel, il est possible de découpler le courant de chauffage qui passe dans la première bande électriquement conductrice (7) du potentiel de polarisation qui est appliqué au nanofil entre les points (17) et (18) (ou plutôt entre les points (19) et (20)) montrés sur la Figure 2.

En d'autres termes, on peut maintenir fixe, par exemple à 1 Volt, la tension de polarisation entre les points (17) et (18) (ou plutôt (19) et (20)) de la

Figure 2, tandis que l'on augmente le courant qui circule dans la première bande électriquement conductrice (7) jusqu'à ce que l'on mesure un courant dans la résistance R, par exemple de quelques nanoampéres.

On peut noter que le courant de fuite dans la résistance R est indicatif, il change selon la chute de potentiel entre les points (17) et (18) sur la Figure 2.

Avantageusement, à l'issue de l'étape e), on réalise les étapes f), g), h) suivantes :
f) on applique une différence de potentiel dite deuxiéme différence de potentiel de polarisation entre la deuxième zone de la surface du nanofil et la première zone de la surface du nanofil, dans le sens de la longueur du nanofil ;
g) on applique une différence de potentiel dite deuxième différence de potentiel de chauffage, entre la première extrémité de la seconde ligne électriquement conductrice et la seconde extrémité de la seconde ligne électriquement conductrice, tout en maintenant constante la deuxième différence de potentiel de polarisation, et on mesure simultanément une différence de potentiel, dite deuxième différence de potentiel de fuite, de part et d'autre d'une résistance R' en série avec le nanofil située entre la seconde extrémité de la première ligne électriquement conductrice et la terre ;
h) on augmente la deuxième différence de potentiel de chauffage de manière continue ou par incrément, de manière manuelle ou automatique, généralement à partir d'une valeur voisine de zéro, jusqu'à ce que l'on observe un saut de la deuxième différence de potentiel de fuite indiquant que la deuxième différence de potentiel de chauffage est alors suffisante pour provoquer un échauffement de la partie centrale de la seconde bande électriquement conductrice et de la deuxième zone de la surface du nanofil, la diffusion du métal ou du métalloïde dans et le long du nanofil et la formation de l'alliage.

C'est lors de cette étape h) que l'on contrôle, maîtrise la longueur du canal du transistor.

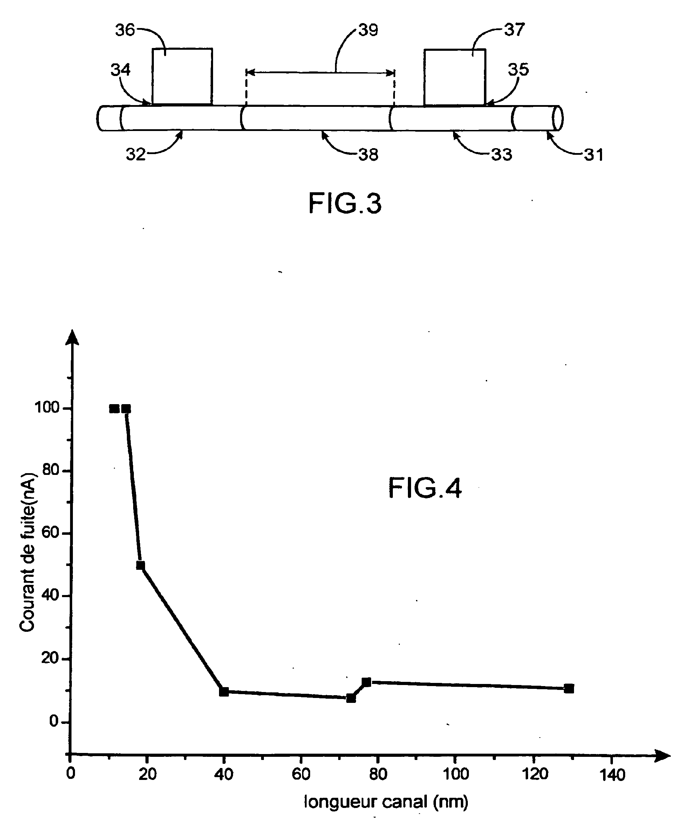

En fait, grâce à une courbe d'étalonnage, telle que celle de la Figure 4, on peut connaître la longueur du canal correspondant à une certaine valeur du courant de fuite mesuré dans la résistance R'ou R.

La Figure 4 montre la longueur du canal mesurée en fonction, du courant de fuite qui circule dans la résistance R ou R'.

Le courant de fuite est mesuré en polarisant le nanofil entre les points (18) et (17) (ou plutôt (20 et 19)) indiqués sur la Figure 2 avec une tension de polarisation constante, par exemple de 1 Volt.

Le potentiel de polarisation dans le nanofil entre les points (18) et (17) est maintenu constant, fixe tandis que l'on augmente le courant de chauffage qui passe dans la bande électriquement conductrice (8) jusqu'à ce que l'on commence à mesurer un courant de fuite qui traverse la résistance R'.

Avantageusement, en fonction de la deuxième différence de potentiel de fuite mesurée, on peut modifier la deuxième différence de potentiel de chauffage.

Avantageusement, la première différence de potentiel de chauffage et/ou la deuxième différence de potentiel de chauffage est(sont) modifiée(s) afin d'obtenir une première portion en alliage et/ou une deuxième portion en alliage de longueur(s) déterminée(s) le long du nanofil à partir respectivement de la première zone de la surface du nanofil et de la deuxième zone de la surface du nanofil.

Avantageusement, la portion en semiconducteur de la longueur du nanofil entre la première portion en alliage et la deuxième portion en alliage est le canal d'un transistor.

Avantageusement, on établit une courbe d'étalonnage qui donne pour chaque valeur du (des) courant(s) de fuite, la longueur du canal du transistor et on règle le premier et/ou le deuxième potentiel de chauffage de manière à obtenir la longueur de canal souhaitée.

Avantageusement, les bandes électriquement conductrices sont définies directement sur les nanofils, par exemple par un procédé de lithographie.

Le procédé selon l'invention n'a pas été décrit ou suggéré dans l'art antérieur.

Le procédé selon l'invention répond à l'ensemble des besoins énumérés plus haut pour un tel procédé et apporte une solution aux problèmes posés par les procédés de l'art antérieur.

On peut dire que le procédé selon l'invention présente notamment, de manière inhérente, tous les effets et avantages dus au fait qu'il est mis en oeuvre avec le dispositif décrit plus haut.

Le procédé selon l'invention permet notamment de contrôler avec précision, fiabilité, le courant de fuite, et donc la formation de l'alliage tel que le siliciure de métal et en particulier la longueur et la profondeur de la partie du nanofil de silicium transformée en alliage, par exemple en siliciure de métal.

L'invention sera mieux comprise à la lecture de la description détaillée qui va suivre donnée à titre illustratif et non limitatif, cette description étant faite en référence aux dessins joints dans lesquels :

### BRÈVE DESCRIPTION DES DESSINS

- La Figure 1 est une microphotographie prise au microscope électronique à balayage (MEB) d'un nanofil de silicium mis en contact avec une électrode en nickel et recuit dans un four à 500°C.
   L'échelle représentée sur la Figure 1 est de 100 nm.
- La Figure 2 est une vue schématique du dessus d'un dispositif selon l'invention, pour la mise en oeuvre du procédé selon l'invention.
- La Figure 3 est une vue schématique d'un transistor à nanofils préparé par le procédé selon l'invention.
- La Figure 4 est un graphique sur lequel est porté en ordonnée le courant de fuite ("leakage current") (en nA) mesuré dans le nanofil, et sur lequel est porté en abscisse la longueur (en nm) du canal d'un transistor à nanofil de silicium préparé par le procédé selon l'invention.
- La Figure 5 est une microphotographie, prise au microscope électronique à balayage qui montre un transistor à nanofil avec son canal, ses portions en siliciure de nickel, et les deux bandes électriquement conductrices (bande (1) et bande (2)) du dispositif mis en oeuvre pour sa préparation.
   L'échelle représentée sur la Figure 5 est de 200 nm.
- La Figure 6 est un graphique qui montre l'évolution dans le temps de la résistance normalisée de la bande (courbe A) et du courant de fuite circulant dans le nanofil (courbe B).
   En ordonnée, à gauche, est portée la résistance normalisée, en ordonnée à droite est portée le courant de fuite (en A), et en abscisse est porté le temps.
- La Figure 7 est une microphotographie prise au microscope électronique à balayage d'un dispositif selon l'invention dans lequel est monté un nanofil de silicium qui a subi un traitement thermique par effet Joule réalisé sur les deux bandes.
   L'échelle représentée sur la Figure 7 est de 200 nm.
- Les Figure 8A et 8B montrent une vue de dessus d'un substrat sur lequel sont disposés plusieurs nanofils et plusieurs dispositifs selon l'invention avec des lignes conductrices comprenant des parties rétrécies.

La Figure 8B est un agrandissement de la partie centrale de la Figure 8A.

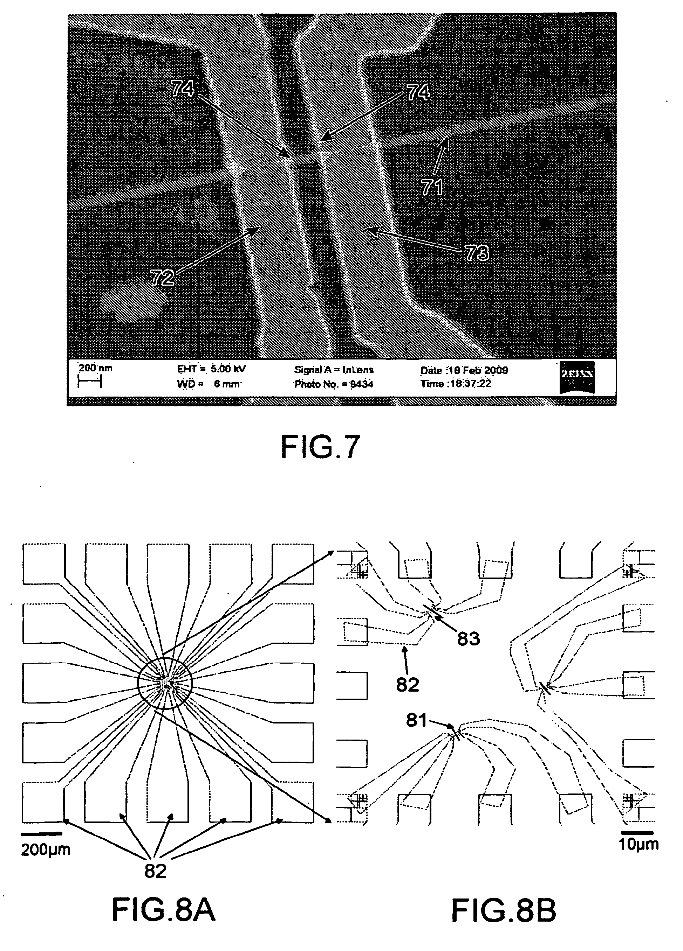

L'échelle représentée sur la Figure 8A est de 200 µm et l'échelle représentée sur la Figure 8B est de 10 µm.

### EXPOSÉ DÉTAILLÉ DE MODES DE RÉALISATION PARTICULIERS

Un dispositif selon l'invention est décrit sur la Figure 2.

Ce dispositif comprend une première ligne (1) électriquement conductrice et une seconde ligne (2) électriquement conductrice.

Les deux lignes (1, 2) sont généralement placées dans un même plan horizontal.

Ces lignes (1, 2) présentent généralement une section transversale rectangulaire ou carrée.

Par exemple, les lignes (1, 2) peuvent avoir une épaisseur, hauteur de 80 à 120 nm et une largeur de 5 à 10 µm

Ces lignes (1, 2) sont électriquement conductrices et sont généralement constituées par un matériau électriquement conducteur qui est choisi parmi les métaux et métalloides, tels que le nickel ou le platine, apte à former des alliages métalliques avec des matériaux semi-conducteurs.

Comme on l'a précisé plus haut, bien que l'invention n'ait été mise en oeuvre effectivement qu'avec le nickel et le platine, l'homme du métier comprendra que le procédé selon l'invention peut également être mis en oeuvre avec succès avec d'autres métaux ou métalloïdes aptes à former des alliages avec des semi-conducteurs.

La première (1) et la seconde (2) lignes électriquement conductrices comprennent chacune une première extrémité (3, 4) et une seconde extrémité (5, 6).

La première ligne électriquement conductrice (1) comprend une première bande conductrice (7) (aussi appelée « stripline » en langue anglaise) qui forme une partie rétrécie (7) entre la première extrémité (3) et la seconde extrémité (5) de la première ligne électriquement conductrice (1) ; et la seconde ligne électriquement conductrice (2) comprend une seconde bande électriquement conductrice (8) (aussi appelée « stripline » en langue anglaise) qui forme une partie rétrécie (8) entre la première extrémité (4) et la seconde extrémité (6) de la seconde ligne électriquement conductrice (2).

Par partie rétrécie (7, 8), on entend généralement que cette partie présente une section, généralement une section transversale inférieure au reste de la première (1) et de la seconde (2) lignes conductrices et plus précisément une section transversale inférieure à la section transversale de la première extrémité (3, 4) et de la seconde extrémité (5, 6) desdites lignes conductrices (1, 2).

A titre d'exemple, la section de la bande conductrice ou partie rétrécie (7) de la première ligne conductrice (1) peut être égale à de 0,01 à 0,1, de préférence 0,05 à 0,1 fois la section transversale de la première extrémité (3) et de la seconde extrémité (5) de la première ligne conductrice (1). Il en est de même pour la bande conductrice (8) de la seconde ligne électriquement conductrice (2).

Typiquement, la section des bandes électriquement conductrices (7, 8) peut être de 10⁴ à 10⁵ nm² alors que la section des lignes électriquement conductrices (1, 2) peut être de l'ordre de 10⁶ nm².

Les valeurs données pour ces sections sont indicatives et ne sont données qu'à titre d'exemple. Elles correspondent aux dimensions typiques qui ont été utilisées dans les exemples.

Le point le plus important à retenir est le rapport entre la section de la bande (7) (respectivement (8)) et la section de la ligne (1) (respectivement (2)) en (3) ou (5) (respectivement en (4) ou (6)).

Comme on l'a déjà indiqué plus haut, une valeur de ce rapport par exemple de 0,01 à 0,1, de préférence de 0,05 à 0,1 semble être raisonnable.

Généralement, la première extrémité (3, 4) et la seconde extrémité (5, 6) de chacune des lignes électriquement conductrices (1, 2) ont une section supérieure à la partie rétrécie (7, 8) de chacune de ces lignes car ces extrémités (3, 4, 5, 6) présentent comme cela est représenté sur la Figure 2, une largeur plus importante que la largeur de la partie rétrécie (7, 8) de chacune des lignes électriquement conductrices (1, 2) tandis que la hauteur, épaisseur des première (3, 4) et seconde extrémités (5, 6) et de la partie rétrécie (7, 8) est généralement identique.

Par exemple, pour des parties rétrécies (7, 8) (« striplines ») d'une largeur de 500 nm, on utilise des lignes (1) et (2) d'une largeur généralement comprise entre 5 et 10 µm.

La hauteur des lignes (1,2) et des parties rétrécies (7, 8) est généralement supérieure au diamètre des nanofils. Pour un nanofil d'un diamètre par exemple de 20 nm, on utilise typiquement des hauteurs entre 80 et 120 nm.

Comme on l'a représenté sur la Figure 2, la première et la seconde bandes conductrices (7, 8) peuvent être parallèles.

Généralement, la première et la seconde bandes électriquement conductrices (7, 8) présentent la même longueur comme on l'a représenté sur la Figure 2.

Cependant il n'est pas nécessaire que les bandes conductrices, "striplines" (7, 8) aient obligatoirement la même longueur.

La première et la seconde bande conductrice (7, 8) ont généralement chacune une longueur de 1 à 5 µm, par exemple de 3 µm.

L'espacement, écart entre les bandes électriquement conductrices (7, 8), a une influence sur le courant de fuite mesuré dans le circuit et sur la formation de l'alliage, par exemple du siliciure de métal.

Plus l'espacement est important, plus le courant de fuite mesuré est faible.

Un espacement d'environ 1 µm entre les bandes électriquement conductrices (7, 8) ne fournit pas généralement de courant de fuite appréciable dans le cas de nanofils non dopés tels que ceux utilisés dans les exemples.

Cependant, la situation peut être différente si les nanofils sont dopés.

De plus, le processus de formation de l'alliage, par exemple le processus de « siliciuration » par chauffage par effet Joule est autolimitant.

En effet, les longueurs des parties en alliage, par exemple en siliciure de métal ou de métalloïde, des nanofils peuvent être au plus d'environ 100 à 150 nm.

Cela signifie que si les deux bandes électriquement conductrices étaient disposées avec un espacement entre elles de 1 µm, la longueur du canal du transistor qui pourrait être formé serait au plus de 700 nm.

Si le procédé doit être utilisé pour fabriquer des transistors avec des longueurs de canaux très courtes, inférieures à 100 nm par exemple comme cela est requis par la feuille de route "ITRS", l'espacement entre les deux bandes électriquement conductrices doit être au plus de 300 nm.

La première et la seconde bandes conductrices (7, 8) sont donc généralement espacées l'une de l'autre de 100 à 1000 nm, de préférence de 100 nm à 300 nm, par exemple de 200 nm.

Le dispositif selon l'invention comprend, en outre généralement, des moyens pour appliquer une différence de potentiel déterminée, dite première différence de potentiel de chauffage V_{chauffage}**,** entre la première extrémité (3) de la première ligne électriquement conductrice (1) et la seconde extrémité (5) de la première ligne électriquement conductrice (1) et faire ainsi passer un courant depuis la première extrémité (3) vers la seconde extrémité (5) de la première ligne électriquement conductrice (1).

Ces moyens comprennent généralement un générateur de tension (9) dont l'une des bornes est reliée à la première extrémité (3) de la première ligne électriquement conductrice (1) par un premier câble (10) et l'autre borne est reliée à la seconde extrémité (5) de la première ligne (1) électriquement conductrice par un second câble (11) qui est généralement également relié à la terre (12).

Avantageusement, le générateur de tension (9) peut comporter des moyens (non représentés) permettant d'augmenter ou de diminuer la tension de chauffage de manière continue ou par incrément, de manière manuelle ou automatique, par exemple en fonction des valeurs mesurées de la première différence de potentiel de fuite.

Le dispositif selon l'invention comprend généralement, en outre, des moyens pour appliquer une différence de potentiel dite première différence de potentiel de polarisation entre la première zone de la surface du nanofil (17) (ou plutôt (19)) et la deuxième zone de la surface du nanofil (18) (ou plutôt (20)) dans le sens de la longueur du nanofil.

Ces moyens pour appliquer une différence de potentiel, dite première différence de potentiel de polarisation sont généralement également constitués par le même générateur de tension (9).

En d'autres termes, le générateur de tension (9) mentionné sur la Figure 2 et qui fournit la première tension de chauffage dans la première ligne (1) doit généralement assurer deux fonctions :
1) Il doit fournir le courant de chauffage voulu, souhaité, généralement réglable, adaptable qui passe dans la bande électriquement conductrice (7) qui cause le chauffage par effet Joule de cette bande électriquement conductrice et qui entraîne la formation d'une phase d'alliage, par exemple d'une phase de siliciure.
2) Il doit fournir la tension de polarisation dans le nanofil entre les points (17) et (18) ((19) et (20)) qui est maintenue, fixe, constante pendant que l'on modifie le courant de chauffage qui passe dans la première bande électriquement conductrice (7).

Afin de permettre au générateur d'accomplir ces deux fonctions, on peut par exemple, comme cela a été le cas dans les expériences réalisées par les inventeurs, utiliser un amplificateur opérationnel.

Un tel dispositif est connu de l'homme du métier et ne sera pas décrit plus en détails.

Des dispositifs autres qu'un amplificateur opérationnel peuvent être utilisés.

L' important est que le générateur (9) puisse fournir le courant de chauffage qui cause le chauffage par effet Joule, ce courant pouvant être modifié de manière continue ou par incrément, et une tension de polarisation, constante, fixe sur la longueur du nanofil entre les points (17) et (18) ((19) et (20)).

La seconde extrémité (6) de la seconde ligne conductrice (2) est reliée à la terre (13) par l'intermédiaire d'un câble (14) sur lequel est placée une résistance R en série avec le nanofil (15) lorsque celui-ci est disposé dans le dispositif selon l'invention.

Des moyens, tels qu'un Voltmètre, sont prévus pour mesurer la différence de potentiel, dite première différence de potentiel de fuite (V_{fuite} ou « Vₗₑₐₖ» en langue anglaise) de part et d'autre de la Résistance R.

La valeur de cette différence de potentiel de fuite reflète le courant (16) qui passe dans le nanofil (15).

On dispose ainsi d'un moyen simple pour contrôler, suivre, la valeur du courant que l'on peut appeler courant de fuite qui circule dans le nanofil (15) et ainsi contrôler, suivre, la formation de l'alliage, par exemple du siliciure de métal.

Comme on l'a déjà vu plus haut, le dispositif selon l'invention peut éventuellement comprendre des moyens (non représentés) permettant de modifier le courant qui passe dans la première ligne électriquement conductrice (1) et dans la premiére bande électriquement conductrice (7), (en effet c'est le même courant qui passe dans la premiére ligne électriquement conductrice (1) et dans la première bande électriquement conductrice (7)) et finalement la quantité de chaleur dissipée par effet Joule au niveau du contact (19) entre le nanofil (15) et la partie de la première bande électriquement conductrice (7) en contact avec celui-ci.

Le dispositif selon l'invention peut également comprendre des moyens permettant de modifier, pour chaque valeur du courant de chauffage, la différence de potentiel appliquée au nanofil entre la première portion ou zone (19) de la surface du nanofil et la seconde portion ou zone (20) de la surface du nanofil.

Il est à noter que dans le dispositif selon l'invention, les rôles de la première ligne électriquement conductrice (1) et de la seconde ligne électriquement conductrice (2) peuvent être inversés c'est-à-dire que le potentiel de chauffage peut être indifféremment appliqué à la première ligne (1) ou à la seconde ligne(2), l'autre ligne étant alors reliée à la terre via une résistance R ou R', dans ce dernier cas, le potentiel de chauffage est appliqué à la seconde ligne (2).

Le dispositif selon l'invention peut comprendre ainsi en outre éventuellement, des moyens pour appliquer une différence de potentiel déterminée, également dite différence de potentiel de chauffage V_{chauffage}, entre la première extrémité (4) de la seconde ligne électriquement conductrice (2) et la seconde extrémité (6) dé la seconde ligne électriquement conductrice (2) et faire ainsi passer un courant depuis la première extrémité (4) vers la seconde extrémité (6) de la seconde ligne électriquement conductrice (2).

Ces moyens comprennent généralement un générateur de tension (appelé (9') par commodité, mais non représenté) dont l'une des bornes est reliée à la première extrémité (4) de la seconde ligne électriquement conductrice (2) par un premier câble et l'autre borne est reliée à la seconde extrémité (6) de la seconde ligne électriquement conductrice (2) par un second câble qui est généralement également relié à la terre.

Avantageusement, le générateur de tension (9') peut comporter des moyens permettant d'augmenter ou de diminuer la tension de chauffage de manière continue ou par incrément, de manière manuelle ou automatique, par exemple en fonction des valeurs mesurées de la différence de potentiel de fuite.

Le dispositif selon l'invention peut comprendre éventuellement, en outre, des moyens pour appliquer une différence de potentiel dite deuxième différence de potentiel de polarisation entre la deuxième zone de la surface du nanofil (18) (ou plutôt (20)) et la première zone de la surface du nanofil (17), ou plutôt (19) dans le sens de la longueur du nanofil.

Ces moyens pour appliquer une différence de potentiel, dite deuxième différence de potentiel de polarisation sont généralement également constitués par le même générateur de tension (9').

Il est à noter qu'un seul générateur peut être utilisé pour remplir à la fois le rôle des générateurs (9) et (9'), ce générateur unique pouvant être relié soit aux extrémités (3, 5) de la première ligne électriquement conductrice (1), soit aux extrémités (4, 6) de la seconde ligne électriquement conductrice (2) par des câbles adéquats.

Lorsque la tension de chauffage est appliquée à la seconde ligne électriquement conductrice (2), la seconde extrémité (5) de la première ligne électriquement conductrice (1) est reliée à la terre par l'intermédiaire d'un câble sur lequel est placée une résistance R' en série avec le nanofil (15), lorsque celui-ci est disposé dans le dispositif selon l'invention.

Des moyens, tels qu'un Voltmètre, sont prévus pour mesurer la différence de potentiel, dite deuxième différence de potentiel de fuite (V_{fulte} ou « Vₗₑₐₖ » en langue anglaise) de part et d'autre de la Résistance R'.

Il est à noter qu'une seule résistance peut être utilisée pour remplir à la fois le rôle des résistances R et R', cette résistance unique pouvant être reliée soit à la deuxième extrémité (5) de la première ligne électriquement conductrice (1) et à la terre, soit à la deuxième extrémité (6) de la deuxième ligne électriquement conductrice (2) et à la terre, par des câbles adéquats.

On va maintenant décrire le procédé selon l'invention qui met généralement en oeuvre le dispositif tel que décrit en détail plus haut et sur la Figure 2.

Dans ce procédé, on commence par déposer des nanofils en un semi-conducteur sur un substrat, par exemple un substrat en forme de couche, ce substrat étant en un matériau électriquement isolant.

Les nanofils peuvent être en tout semi-conducteur qui peut former un alliage avec un métal ou métalloïde. Ce métal ou métalloïde est bien entendu différent du semi-conducteur des nanofils.

De préférence, les nanofils sont des nanofils de silicium, éventuellement dopés.

Les nanofils tels que des nanofils de silicium peuvent être préparés par tout procédé adéquat.

Par exemple, les nanofils de silicium peuvent être préparés par croissance sur un substrat à l'aide d'un procédé de dépôt chimique en phase vapeur (« Chemical Vapour Deposition » ou « CVD » en langue anglaise) puis séparés de ce substrat.

Ou bien les nanofils de silicium peuvent être préparés par le procédé d'attaque standard utilisé dans l'industrie pour la fabrication des circuits intégrés.

Le procédé selon l'invention peut être mis en oeuvre avec succès avec toutes sortes de nanofils quels que soient leurs diamètres ou longueurs.

Avantageusement, les nanofils, peuvent avoir une longueur de 0,5 à 10 µm et un diamètre de 20 à 50 nm.

Les nanofils qui ont été utilisés pour mettre en oeuvre l'invention notamment dans les exemples joints, ont généralement une longueur de l'ordre de 10 µm et un diamètre de 20 à 50 nm.

Cependant, l'invention peut aussi être mise en oeuvre avec des nanofils de plus petit ou de plus grand diamètre à la condition que leur longueur soit d'au moins 0,5 µm.

Tout type de matériau électriquement isolant qui est thermiquement stable peut être utilisé pour constituer le substrat électriquement isolant, par exemple la couche électriquement isolante sur laquelle sont déposés les nanofils.

Le substrat électriquement isolant peut éventuellement jouer aussi le rôle de puits thermique (« thermal sink » en anglais). En conséquence, le matériau du substrat électriquement isolant peut éventuellement mais pas nécessairement être aussi thermiquement conducteur.

On peut penser que les propriétés thermiques du substrat isolant peuvent avoir une influence sur le procédé, par exemple sur la pénétration maximale des alliages tels que les siliciures formés.

En d'autres termes, en utilisant un substrat électriquement isolant avec une conductivité thermique plus faible, il peut être éventuellement possible d'obtenir une profondeur de pénétration plus importante des alliages, tels que les siliciures, formés.

Ce qui est important est que le substrat électriquement isolant puisse supporter des températures supérieures à celles requises pour que se forme l'alliage métal (métalloïde) semi-conducteur, c'est-à-dire plusieurs centaines de degrés Celsius.

Ainsi, dans le cas de nanofils en silicium préparés par croissance sur un substrat à l'aide d'un procédé de dépôt en phase vapeur, on pourra les déposer sur un substrat, par exemple un substrat sous la forme d'une couche, en silice, en nitrure de silicium ou en alumine.

Il ne s'agit là que d'exemples de substrats, par exemple sous la forme de couches, où l'on peut déposer les nanofils.

D'autres substrats peuvent être utilisés, le point important étant que les nanofils soient déposés sur un substrat isolant qui est également thermiquement stable.

Le substrat, notamment lorsqu'il est sous la forme d'une couche, en matériau électriquement isolant peut être disposé au sommet d'un autre substrat en un autre matériau.

Par exemple, les nanofils, par exemple en silicium, peuvent être déposé sur une couche de SiO₂, par exemple d'une épaisseur de 300 nm, au sommet d'un substrat en silicium fortement dopé.

Toutefois, la présence d'un substrat fortement dopé n'affecte pas le procédé, car le point important est que les nanofils doivent être déposés sur un substrat, par exemple une couche, électriquement isolante.

Pour déposer les nanofils, par exemple en silicium, sur le substrat, par exemple la couche, en un matériau électriquement isolant, on peut par exemple les disperser dans un solvant adéquat, tel qu'un alcool comme l'isopropanol et déposer cette solution sur la couche en un matériau électriquement isolant. Une fois le solvant évaporé, on obtient une couche sur laquelle les nanofils sont déposés.

Les positions des nanofils déposés sur la couche sont généralement aléatoires. Les nanofils peuvent cependant être repérés, localisés sur la couche à l'aide de marques préalablement définies, réalisées sur la couche.

Le fait que les nanofils occupent des positions, emplacements aléatoires sur le substrat n'a pas d'impact sur le procédé car une fois que les nanofils sont déposés sur la surface, ils peuvent être facilement localisés, éventuellement à l'aide des marques mentionnées plus haut.

Toutefois, le procédé selon l'invention peut être facilement adapté dans le cas où l'on souhaite que les nanofils soient disposés selon des structures, motifs ordonnés, par exemple sous la forme de rangées ordonnées de nanofils disposés dans un plan.

Dans ce cas, il est nécessaire de mieux contrôler les positions spécifiques des nanofils.

Cela est possible avec différentes techniques telles que les techniques de di-électrophorèse ou les techniques microfluidiques qui permettent de positionner les nanofils à des emplacements spécifiques, par exemple qui permettent de disposer les nanofils parallèlement.

En disposant les nanofils selon des structures, motifs ordonnés, par exemple sous la forme de rangées ordonnées de nanofils disposés dans un plan, le procédé selon l'invention peut avoir une capacité de production élevée.

Les nanofils adhèrent au substrat, tel qu'une couche, sous l'action de forces de Van der Waals. Une fois qu'ils sont déposés, les nanofils ne se déplacent plus et restent à l'endroit où ils ont été initialement déposés.

L'étape suivante du procédé selon l'invention ou étape de mise en contact (étape b)) peut comprendre une opération au cours de laquelle on recouvre les nanofils en un semi-conducteur d'une couche de métal ou de métalloïde en vue de former les bandes électriquement conductrices (7, 8).

Avant de déposer le métal sur le nanofil, on élimine généralement la couche d'oxyde natif, par exemple de SiO₂ dans le cas de nanofils en silicium, à la surface des nanofils par exemple par trempage dans une solution de HF tamponnée (« Buffered HF » ou BHF en langue anglaise).

Le dépôt du métal peut être réalisé sur la première portion ou zone (19) de la surface du nanofil en silicium qui va se trouver en contact avec la partie centrale (17) de la partie rétrécie (7) entre la première extrémité (3) et la seconde extrémité (5) de la première ligne conductrice (1) et sur la deuxième portion ou zone (20) de la surface du nanofil qui va se trouver en contact avec la partie centrale (18) de la partie rétrécie (8) entre la première extrémité (4) et la seconde extrémité (6) de la seconde ligne conductrice (2).

Le métal qui recouvre les nanofils est choisi de préférence parmi le nickel, le platine et tous les matériaux aptes à former des alliages métalliques avec les semi-conducteurs composant le nanofil.

Il a été mis en évidence que le procédé fonctionnait particulièrement bien avec le nickel, mais aussi avec le platine qui est avec le nickel, l'autre matériau couramment utilisé dans l'industrie microélectronique pour fabriquer les contacts de transistors.

La quantité de métal déposée sur le nanofil dépend du diamètre du nanofil. Des nanofils de plus grand diamètre nécessitent de plus grandes quantités de métal.

L'épaisseur de la couche du métal ou métalloïde utilisé pour cette invention est généralement de à 120 nm. Cette épaisseur peut être modifiée en fonction fonction du diamètre des nanofils semi-conducteurs.

Généralement, l'épaisseur doit être d'au moins deux fois le diamètre du nanofil.

Ainsi, une épaisseur typique est d'environ 120 nm pour des nanofils d'un diamètre de 20 nm à 50 nm.

Le dépôt du métal ou métalloïde sur les nanofils peut être réalisé par tout procédé de dépôt de métal. Ce dépôt est généralement réalisé par un procédé d'évaporation de métal par faisceau d'électrons (« E-Beam Metal Evaporation » en langue anglaise) dans lequel une cible métallique est bombardée par un faisceau d'électrons, ce qui provoque l'évaporation du métal de la cible.

Un autre procédé de dépôt est la pulvérisation cathodique. Le dépôt par pulvérisation cathodique est avantageusement utilisé pour le dépôt de contacts en platine.

Lors de l'étape b) du procédé, on met en contact la première zone de la surface du nanofil (15) par exemple en silicium, avec la partie centrale (17) de la bande électriquement conductrice (7) entre la première extrémité (3) et la seconde extrémité (5) de la première ligne électriquement conductrice (1) et on met en contact une seconde zone de la surface du nanofil espacée de la première zone dans le sens de la longueur du nanofil, avec la partie centrale (18) de la bande électriquement conductrice (8) entre la première extrémité (4) et la seconde extrémité (6) de la seconde ligne électriquement conductrice (2).

On a vu plus haut que la première (7) et la seconde (8) bandes conductrices sont généralement espacées l'une de l'autre de 100 nm à 300 nm, par exemple de 200 nm, de ce fait la première et la seconde zones du nanofil sont généralement espacées l'une de l'autre de 100 nm à 300 nm, par exemple de 200 nm.

Généralement, la première et la seconde zones du nanofil sont mises en contact généralement au centre ou quasiment au centre de chacune des deux parties centrales (17, 18), c'est-à-dire au centre ou quasiment au centre de chacune des deux bandes électriquement conductrices (7, 8) et de chacune des deux lignes (1, 2).

La mise en contact peut en outre comprendre une opération au cours de laquelle on définit effectivement des bandes électriquement conductrices sur les nanofils, par exemple par lithographie.

Par « presque au centre ou quasiment au centre », on entend que le nanofil est positionné avec une précision d'environ 200 nm ou moins et de préférence d'environ 50 nm ou moins, pour des bandes conductrices parallèles (7, 8) par exemple d'une longueur de 3 µm et séparées de 200 nm.

Il est à noter que la précision de 200 nm est la précision qui a été obtenue avec le système de lithographie mis en oeuvre dans les exemples, mais des systèmes de lithographie perfectionnés peuvent permettre d'obtenir une précision dans le positionnement du nanofil qui est beaucoup plus élevée, par exemple de l'ordre de 50 nm ou moins.

Cependant, avec une précision de 200 nm, il a été constaté que le procédé fonctionnait très bien.

Le nanofil est généralement placé en-dessous des deux bandes conductrices (7, 8) comme cela est représenté sur la Figure 2 et en contact avec chacune de ces bandes.

Les Figures 8A et 8B montrent une vue de dessus d'un substrat sur lequel sont disposés plusieurs nanofils (81) et plusieurs dispositifs selon l'invention avec des lignes conductrices (82) comprenant des parties rétrécies ou bandes (83).

Une fois le nanofil ainsi disposé, on applique une différence de potentiel, dite première différence de potentiel de chauffage V_{chauffage}, entre la première extrémité (3) de la première ligne électriquement conductrice (1) et la seconde extrémité (5) de la première ligne électriquement conductrice en un métal ou métalloïde (1), cette différence de potentiel étant suffisante pour provoquer un échauffement de la partie centrale (17) de la partie rétrécie (7) de la première ligne électriquement conductrice (1) et de la première zone de la surface du nanofil tel que le métal ou le métalloïde diffuse dans le nanofil (15) pour former un alliage avec le semi-conducteur, tel qu'un siliciure de métal.

Comme on l'a déjà indiqué plus haut, le générateur de courant (9) est capable de fournir le courant de chauffage qui provoque le chauffage par effet Joule de la bande (7), et ce même générateur, pour chaque valeur du courant de chauffage qui traverse la bande (7) peut fournir une tension de polarisation fixe, constante dans le nanofil entre les points (17) et (18).

On peut ainsi augmenter progressivement ou par incrément la différence de potentiel appliquée à la première ligne conductrice (1) généralement depuis un potentiel nul, pour atteindre une valeur du courant telle qu'elle provoque un échauffement par effet Joule de la bande électriquement conductrice (7).

Un courant d'environ 15 à 20 mA, par exemple, est généralement suffisant pour provoquer la diffusion du métal ou du métalloïde de la bande conductrice dans le nanofil et donc la formation d'un alliage tel qu'un siliciure.

Plus précisément, chaque valeur du courant provoque un accroissement instantané de la température de la bande électriquement conductrice (« stripline »), mais les inventeurs ont pu montrer qu'une valeur du courant généralement entre 15 and 20 mA donnait lieu à la formation d'un alliage, tel qu'un siliciure.

Ce courant, généralement d'environ 15 à 20 mA est donc le courant assurant un échauffement, ou plus exactement une élévation de la température de la partie centrale (17) de la partie rétrécie (7) de la première ligne électriquement conductrice (1) telle qu'elle assure la diffusion du métal à l'intérieur du nanofil (15).

Les incréments avec lesquels on augmente la différence de potentiel de chauffage V_{chauffage} peuvent être par exemple des incréments de 0,1 Volt.

Pour chaque valeur de V_{chauffage}, la différence de potentiel entre les deux extrémités du nanofil est maintenue à une valeur fixe, par exemple de 1 Volt. Cette différence de potentiel donne lieu à un courant de fuite à travers le nanofil dont la valeur est directement reliée à la longueur du canal semi-conducteur, qui dépend de la longueur de pénétration du métal dans le nanofil. Ce courant de fuite est utilisé comme paramètre de rétroaction pour contrôler l'alliage des contacts et arrêter le procédé à la longueur du canal désirée.

Il est bien évident que la valeur de la différence de potentiel V_{Chauffage} qui permet d'obtenir un échauffement de la partie centrale (17) de la partie rétrécie de la première ligne électriquement conductrice (1) et une diffusion du métal varie en fonction de la résistance de la premiére ligne électriquement conductrice (1) et de la premiére bande électriquement conductrice (7).

De manière générale pour des lignes et bandes conductrices classiques, cette différence de potentiel pourra être par exemple de 1 à 2 Volts.

Si l'on considère la résistance normalisée de la ligne conductrice et de la bande conductrice, qui est le rapport entre la résistance R(I) (R'(I)) de la ligne et de la bande dans laquelle passe un courant d'intensité I et la résistance de la même ligne et de la même bande à une très faible polarisation, ce rapport sera supérieur à un dès qu'il y a une dissipation de chaleur, due par exemple à une température plus élevée du métal de la partie centrale de la partie rétrécie de la ligne conductrice, près du milieu de la bande.

On peut considérer qu'il y a un échauffement à partir d'une résistance normalisée de 1 mais qu'il faut augmenter V_{chauffage} et donc la résistance normalisée au-dessus de 1,2 voire 1,3 pour que le courant de fuite augmente et donc l'alliage, tel qu'un siliciure se forme.

En d'autres termes, il a été mis en évidence, comme on l'a déjà mentionné plus haut, que la formation d'un alliage, tel qu'un siliciure, est accomplie en faisant passer un courant entre 15 et 20 mA dans la ligne électriquement conductrice et dans la bande électriquement conductrice (c'est le même courant qui passe dans la ligne et dans la bande).

Si l'on s'intéresse à la résistance normalisée, on a trouvé expérimentalement que ces valeurs du courant de chauffage correspondent à des valeurs de la résistance normalisée comprises entre 1,2 et 1,3.

Comme le prouve la Figure 6, lorsque la résistance normalisée atteint une valeur comprise entre 1,2 et 1,3, on commence à mesurer un courant non négligeable qui traverse le nanofil et qui indique la formation d'une phase d'alliage, par exemple d'une phase de siliciure.

Sans vouloir être lié par aucune théorie, et comme on l'a déjà indiqué plus haut, la partie rétrécie (7, 8) des lignes conductrices (1, 2) constitue une gêne locale pour le passage du courant dans la bande conductrice. En d'autres termes, cette partie rétrécie constitue, un resserrement, un rétrécissement, une « constriction » pour le passage du courant. En conséquence, une température très élevée est atteinte dans la partie centrale de la bande électriquement conductrice où se trouve positionné le nanofil.

Cette température très élevée peut être par exemple de 400 à 1000°C. Elle doit être suffisante pour activer le processus de diffusion du métal dans le nanofil et en même temps, elle ne doit pas excéder la température de fusion du métal afin de ne pas provoquer sa rupture.

Le point le plus chaud correspond généralement au milieu de la partie rétrécie de la ligne conductrice.

Le chauffage local du contact du fait de la dissipation de chaleur par effet Joule provoque un « recuit » du contact.

En d'autres termes, le métal constituant la bande conductrice, et qui généralement recouvre le nanofil, commence à diffuser à l'intérieur du nanofil, dans le sens de l'épaisseur du nanofil mais aussi généralement dans le sens de la longueur de celui-ci, pour former un alliage entre le métal ou métalloïde constituant la bande conductrice, qui recouvre généralement le nanofil et le semi-conducteur du nanofil tel que le silicium. Cet alliage est, par exemple, un siliciure de métal.

Selon l'invention, la longueur de la partie du nanofil de silicium où est formé l'alliage du métal ou métalloïde et du semi-conducteur, tel qu'un siliciure de métal est auto-limitante.

Cela est dû à la présence de la couche de matériau électriquement isolant tel que du SiO₂ sur laquelle sont déposés les nanofils et qui joue le rôle de drain, ou puits thermique. Ainsi, la longueur de la partie siliciée autour du contact entre la première bande conductrice et le nanofil est auto-limitée, par exemple à environ 150 nm.

Selon l'invention, on mesure en outre une différence de potentiel, dite différence de potentiel de fuite, de part et d'autre d'une résistance R en série avec le nanofil située entre la seconde extrémité (6) de la seconde ligne (2) électriquement conductrice et la terre.

Grace à cette mesure du potentiel de fuite, on peut ainsi suivre, contrôler, simultanément le courant appelé courant de fuite (16) qui passe dans le nanofil de silicium (15) puis dans la seconde bande électriquement conductrice (8) et enfin dans la résistance R.

Il a été constaté que la valeur du courant de fuite correspondant à une tension de polarisation entre les points (17) et (18), ou plutôt entre les points (19) et (20) du nanofil, de 1 Volt, restait constante et voisine de zéro jusqu'à une valeur de la résistance normalisée de la première ligne conductrice généralement égale à 1 puis augmentait brutalement à partir d'une valeur déterminée de la résistance normalisée pour atteindre par exemple environ 7 nA.

Plus précisément, on commence par polariser la nanofil, par exemple avec une tension de 1 Volt, par exemple entre les points (17) et (18), ou plutôt (19) et (20).

Puis, on augmente le courant de chauffage qui passe dans la dans la premiére ligne électriquement conductrice (1) et dans la premiére bande électriquement conductrice (7) (c'est le même courant qui passe dans la ligne et dans la bande) jusqu'à une valeur comprise généralement entre 15 et 20 mA tout en maintenant fixe à 1 Volt le potentiel de polarisation, entre les points (17) et (18) ou plutôt (19) et (20).

A un certain moment, on commence à mesurer un courant de l'ordre de quelques nanoampères qui passe dans la résistance R, et c'est alors que l'alliage, tel qu'un siliciure se forme.

On dispose ainsi d'un moyen de contrôler, réguler, la pénétration, l'infiltration, du métal ou métalloïde dans le nanofil en épaisseur et généralement en profondeur.

Plus précisément, on pourrait plutôt dire que l'on contrôle, maîtrise, régule, la pénétration de l'alliage, tel qu'un siliciure tout au long de la longueur du nanofil.

On peut déclencher, stopper ou accélérer la diffusion du métal ou métalloïde et la formation de l'alliage, par exemple du siliciure de métal en modifiant la valeur de la différence de potentiel appliquée à la première ligne électriquement conductrice (1) et, par conséquent, la valeur de l'intensité du courant de chauffage qui passe dans cette premiére ligne électriquement conductrice et dans la premiére bande électriquement conductrice (c'est le même courant qui passe dans la ligne et dans la bande).

Le procédé selon l'invention, contrairement aux procédés qui mettent en oeuvre un recuit dans un four permet un contrôle électrique du processus d'alliage métal/semi-conducteur. Ce contrôle s'effectue *in*-*situ* grâce à une surveillance, un monitorage (« monitoring » en anglais) du courant de fuite et à une rétroaction sur le courant de chauffage.

Ce procédé est fiable et reproductible car les bandes électriquement conductrices définies par exemple par lithographie sur les nanofils ont toujours la même géométrie et la même résistance, comme cela a pu être mis en évidence par des mesures de résistance à quatre sondes. La résistance globale et la géométrie de la ligne, connexion métallique (1) ou (2), dans laquelle se trouve incluse la bande électriquement conductrice (7) ou (8) peuvent varier mais le processus conduisant à la formation de l'alliage, par exemple à la formation du siliciure de métal est régi par la bande électriquement conductrice (7) ou (8) et par elle-seule.

En effet, ce processus est régi par la puissance dissipée dans les bandes conductrices (7) et (8) par effet Joule qui à son tour dépend uniquement de la résistance de la bande conductrice.

Dans le cas où l'on souhaite préparer un transistor, après avoir préparé un alliage tel qu'un siliciure de métal au niveau de la première zone du nanofil (19), on inverse les rôles joués par la première et la seconde lignes électriquement conductrices (1, 2) et on applique une différence de potentiel, dite deuxième différence de potentiel de chauffage entre la première extrémité (4) de la seconde ligne électriquement conductrice (2), et la seconde extrémité (6) de la seconde ligne électriquement conductrice (2), cette différence de potentiel étant suffisante pour provoquer un échauffement de la partie centrale (18) de la bande électriquement conductrice (8) de la seconde ligne électriquement conductrice (2), et de la deuxième zone de la surface du nanofil (20) tel que le métal ou métalloïde diffuse dans le nanofil (15) pour former un alliage de métal ou métalloïde tel qu'un siliciure de métal.

En même temps, la différence de potentiel entre les points de contact (19) et (20) est maintenue fixe, par exemple à 1 Volt, afin de produire un courant de fuite à travers le nanofil tout en permettant une rétroaction sur le processus d'alliage au niveau du deuxième contact (20).

La longueur du canal du transistor, déterminée par la longueur de pénétration de l'alliage métal/semi-conducteur au niveau du deuxième contact (20), est directement reliée au courant de fuite. Dès que la longueur du canal se réduit, le courant de fuite augmente.

Comme on peut le voir sur la Figure 3, un tel transistor formé dans un nanofil (31), en un semi-conducteur comprend deux parties (32, 33) en alliage du semi-conducteur et du métal ou métalloïde, par exemple en siliciure de métal, tel que le siliciure de nickel. Ces parties (32, 33) sont formées dans le nanofil depuis les contacts (34, 35) entre les première et seconde bandes électriquement conductrices (36, 37) et le nanofil (31) et une partie centrale (38) en semi-conducteur, par exemple en silicium. Cette partie centrale du nanofil constitue le canal du transistor.

Comme on l'a précisé plus haut, dans le procédé selon l'invention, on réalise un contrôle électrique de la longueur (39) du canal du transistor en observant le courant de fuite (premier et deuxième courants de fuite).

La courbe de la Figure 4 montre que l'on peut effectivement régler la longueur du canal d'un transistor à nanofil en ajustant la valeur du courant de fuite

La microphotographie de la Figure 5 ainsi que la Figure 7, démontrent que le procédé selon l'invention permet de fabriquer des transistors à nanofils de silicium avec des longueurs de canal d'environ 20 nm.

L'invention va maintenant être décrite en référence à l'exemple suivant donné à titre illustratif et non limitatif.

### Exemple :

On fait croître des nanofils de silicium sur un substrat par un procédé de dépôt chimique en phase vapeur (« CVD »).

Les nanofils sont ensuite séparés du substrat de croissance au moyen d'une légère agitation avec des ultrasons qui provoque leur libération dans une solution d'isopropanol.

Puis, les nanofils sont dispersés à l'aide d'une pipette sur un substrat en silicium fortement dopé recouvert par une couche d'oxyde thermique de haute qualité d'une épaisseur d'environ 300 nm.

Le substrat en silicium fortement dopé est utilisé comme une électrode de grille.

La position des nanofils sur le substrat est repérée à l'aide de marques d'alignement préexistantes. Les contacts métalliques sur chacun des nanofils sont définis par une étape de lithographie par faisceau d'électrons, une étape de dépôt de métal par faisceau d'électrons (120 nm de nickel), et une étape de « lift-off » par immersion dans l'acétone pendant 10 minutes à environ 55°C.

Avant le dépôt du métal, l'oxyde natif sur la surface des nanofils est éliminé par trempage pendant 5 secondes dans de l'acide fluorhydrique tamponnée (« BHF ») 5/1 contenant 5,40 % de NH₄F et 1,49% de HF.

Le dispositif pour former un siliciure de métal sur les nanofils mis en oeuvre dans cet exemple est le dispositif décrit sur la Figure 2.

Plus précisément des nanofils en silicium ont été synthétisés à partir de nanoparticules d'or dans un réacteur de dépôt chimique en phase vapeur CVD (« Chemical Vapour Deposition » ou « CVD » en langue anglaise).

Les nanofils sont des nanofils non dopés avec des diamètres de 20 à 40 nm.

La fabrication des dispositifs selon l'invention, en vue de mettre en oeuvre le procédé selon l'invention, est faite de la façon suivante :
1. on dépose les nanofils de silicium sur un substrat de silicium fortement dopé, avec une couche superficielle d'oxyde thermique d'environ 300 nm d'épaisseur ;
2. on dépose une couche de PMMA (Poly (Méthacrylate de Méthyle)) et on repère la position des nanofils par rapport à un réseau prédéfini de plots métalliques, dits repères « markers » d'alignement ;
3. on expose la surface à un faisceau d'électrons afin de définir des lignes qui seront successivement métallisées ;
4. l'échantillon est mis dans une solution de Methyl Isobutyl Cétone (« MIK ») et d'isopropanol qui enlève uniquement le PMMA exposé au faisceau électronique ;
5. l'échantillon est immergé pendant environ 6 secondes dans une solution « BHF» à base d'acide fluorhydrique afin d'éliminer la couche d'oxyde de silicium qui recouvre la surface exposée des nanofils ;
6. juste après cette attaque chimique, l'échantillon est transféré dans un bâti de pulvérisation électronique et une couche d'environ 80 à 120 nm de métal, par exemple de nickel, est déposée ;
7. la fabrication de l'échantillon est complétée avec un processus dit de « lift-off » effectué dans un bain d'acétone qui enlève le PMMA et la couche de métal au-dessus. Par conséquent, le métal reste uniquement en correspondance des lignes définies par le faisceau électronique et qui deviennent, pour chaque nanofil contacté, les lignes métalliques (1) et (2) et les bandes métalliques (7) et (8), disposées parallèlement l'une à l'autre, ces deux bandes étant chacune perpendiculaires au nanofil.
Chacune des bandes (7, 8) a généralement une longueur de 3 µm et les deux bandes sont généralement séparées de 200 nm.

Le nanofil se trouve donc disposé sous chacune des bandes et est au contact de celles-ci sensiblement au milieu de chacune d'elles, avec une précision par exemple d'environ 200 nm.

Avec un générateur de tension, on fait croître la différence de potentiel V_{chauffage} dans la première ligne (1), en gardant une différence de potentiel fixe, par exemple de 1 Volt, entre les points (17) et (18), ou plutôt (19) et (20), afin de produire un courant de fuite pour le monitorage du processus.

Le courant de chauffage, induit par la différence de potentiel V_{Chauffage}, peut atteindre une valeur d'environ 15 à 20 mA. La différence de potentiel appliquée entre les points (3) et (5) est d'environ 1 Volt.

La bande (7) agit comme une constriction au passage du courant, de sorte qu'une température très élevée est atteinte dans la portion centrale (17) de la bande métallique (7), là où le nanofil est en contact avec la bande (7).

Le chauffage local du contact par effet Joule provoque un recuit du contact. En d'autres termes, le métal, tel que le nickel, qui recouvre le nanofil, commence à diffuser vers l'intérieur du nanofil pour former un alliage métallique, par exemple de nickel et de silicium, c'est-à-dire un siliciure métallique.

Grâce à l'appareil mis en oeuvre selon l'invention, il est possible de contrôler en même temps le courant qui passe dans le nanofil en mesurant la différence de potentiel V_{fuite} dans la résistance R qui est disposée en série avec le nanofil à l'extrémité de la seconde ligne (2).

Afin de pouvoir suivre en temps réel les modifications qui sont induites dans la morphologie du nanofil, les expériences ont été réalisées avec un MEB équipé pour effectuer des mesures électriques tout en observant le nanofil.

Sur la Figure 6, on a porté les valeurs mesurées du courant de fuite (courbe B) qui passe dans le nanofil en fonction de temps ainsi que la valeur de la résistance normalisée (courbe A) de la première ligne(1).

La résistance normalisée de la première ligne(1) (est le rapport entre la résistance R(I) de la bande dans laquelle passe un courant d'intensité I, et la résistance de la bande à une très faible polarisation.

Ce rapport est supérieur à 1 dès qu'il y a une dissipation de chaleur, due par exemple à une température plus élevée du métal près du milieu de la bande.

Lorsque l'on augmente le potentiel par incréments de 0,1 V, on mesure des incréments de la résistance normalisée qui montrent que pour chaque valeur de la différence de potentiel que l'on applique, on induit un chauffage instantané du métal. Le courant de fuite dans le nanofil reste constant jusqu'à ce que la résistance normalisée de la ligne atteigne une valeur proche de 1, 3, ce qui correspond à une valeur du courant qui passe dans le nanofil d'environ 7 nA (voir Figure 6).

La Figure 7 est une microphotographie prise au MEB du dispositif avec lequel un traitement de chauffage par effet Joule a été réalisé des deux côtés du nanofil (71); c'est-à-dire que la tension de chauffage a tout d'abord été appliquée à la première bande (72), aucune tension de chauffage n'étant appliquée à la seconde bande (73) puis la tension de chauffage a été appliquée à la seconde bande (73), aucune tension de chauffage n'étant appliquée à la première bande (72).

Comme le montre de manière évidente la photographie, des régions plus claires, indiquées par les flèches (74), juste en-dessous de chaque contact, apparaissent après le traitement. Ces régions plus claires correspondent à des régions siliciées de siliciure de nickel.

La photographie démontre donc qu'un chauffage local par effet Joule peut effectivement former un siliciure sur un nanofil de silicium.

De plus, en mesurant en même temps le courant de fuite qui passe dans le nanofil, il y ainsi un moyen de contrôler la pénétration du métal le long du nanofil et éventuellement en principe, également la profondeur de la pénétration, du métal.

## Revendications

1. Dispositif configuré pour former sur un nanofil en un semi-conducteur (15), un alliage de ce semi-conducteur avec un métal ou un metalloïde, ledit dispositif comprenant :
- une première bande électriquement conductrice (7) en un métal ou un métalloïde apte à former un alliage avec le semi-conducteur du nanofil (15), et une seconde bande électriquement conductrice (8) en un métal ou un métalloïde apte à former un alliage avec le semi-conducteur du nanofil, espacées l'une de l'autre, la première (7) et la seconde (8) bandes électriquement conductrices, par exemple en nickel ou en platine, étant de préférence parallèles et formant une partie rétrécie respectivement d'une première ligne électriquement conductrice (1) et d'une seconde ligne électriquement conductrice (2), lesdites première (1) et seconde (2) lignes électriquement conductrices comprenant chacune une première extrémité (3, 4) et une seconde extrémité (5, 6), la partie centrale (17) de la première bande électriquement conductrice (7) étant apte à être mise en contact avec une première zone (19) de la surface du nanofil et la partie centrale (18) de la seconde bande électriquement conductrice (8) étant apte à être mise en contact avec une deuxième zone (20) de la surface du nanofil, espacée de la première zone (19) dans le sens de la longueur du nanofil ;
- des moyens (9, 10, 11) pour appliquer une différence de potentiel, entre la première extrémité (3) de la première ligne électriquement conductrice (1) et la seconde extrémité (5) de la première ligne électriquement conductrice (1) et faire passer un courant depuis la première extrémité (3) vers la seconde extrémité (5) de la première ligne électriquement conductrice (1) pour provoquer un échauffement de la partie centrale (17) de la première bande électriquement conductrice (7), et des moyens (14) pour relier la seconde extrémité (6) de la seconde ligne électriquement conductrice (2) à la terre (13), lesdits moyens comprenant une résistance R;
- éventuellement, des moyens pour appliquer une différence de potentiel, entre la première extrémité (4) de la seconde ligne électriquement conductrice (2) et la seconde extrémité (6) de la seconde ligne électriquement conductrice (2) lorsqu'aucune différence de potentiel n'est appliquée entre la première extrémité (3) de la première ligne électriquement conductrice (1) et la seconde extrémité (5) de la première ligne électriquement conductrice (1) et faire passer un courant depuis la première extrémité (4) vers la seconde extrémité (6) de la seconde ligne électriquement conductrice (2), et éventuellement des moyens pour relier la seconde extrémité (5) de la première ligne électriquement conductrice (1) à la terre, lesdits moyens comprenant une résistance R' ;
- des moyens pour mesurer une différence de potentiel, dite première différence de potentiel de fuite de part et d'autre de la résistance R ;
- éventuellement, des moyens pour mesurer une différence de potentiel, dite deuxième différence de potentiel de fuite de part et d'autre de la résistance R' ;
- des moyens pour appliquer une différence de potentiel, dite première différence de potentiel de polarisation entre la première zone (19) de la surface du nanofil et la deuxième zone (20) de la surface du nanofil, dans le sens de la longueur du nanofil ;
- éventuellement, des moyens pour appliquer une différence de potentiel, dite deuxième différence de potentiel de polarisation entre la deuxième zone (20) de la surface du nanofil et la première zone (19) de la surface du nanofil (15), dans le sens de la longueur du nanofil lorsque la première différence de potentiel de polarisation n'est pas appliquée.

2. Dispositif selon la revendication 1, dans lequel la première (7) et la seconde (8) bandes électriquement conductrices ont chacune une longueur de 1 à 5 µm, par exemple de 3 µm, et/ou la première (7) et la seconde (8) bandes électriquement conductrices sont espacées l'une de l'autre de 100 nm à 300 nm, par exemple de 200 nm à 300 nm.

3. Dispositif selon l'une quelconque des revendications précédentes, dans lequel les moyens (9, 10, 11) pour appliquer une différence de potentiel, entre la première extrémité (3) de la première ligne électriquement conductrice (1) et la seconde extrémité (5) de la première ligne électriquement conductrice (1), et les moyens éventuels pour appliquer une différence de potentiel, entre la première extrémité (4) de la seconde ligne électriquement conductrice(2) et la seconde extrémité (6) de la seconde ligne électriquement conductrice (2) comportent des moyens pour augmenter ou diminuer cette(ces) différence(s) de potentiel de manière continue ou par incrément, de manière manuelle ou automatique, par exemple en fonction de la valeur mesurée de la première différence de potentiel de fuite, respectivement de la deuxième différence de potentiel de fuite.

4. Dispositif selon l'une quelconque des revendications précédentes, dans lequel les moyens (9, 10, 11) pour appliquer une différence de potentiel, entre la première extrémité (3) de la première ligne électriquement conductrice (1) et la seconde extrémité (5) de la première ligne électriquement conductrice (1) et les moyens pour appliquer une différence de potentiel, dite première différence de potentiel de polarisation entre la première zone (19) de la surface du nanofil (15) et la deuxième zone (20) de la surface du nanofil (15), dans le sens de la longueur du nanofil sont constitués par un même premier générateur de tension.

5. Dispositif selon l'une quelconque des revendications précédentes, dans lequel les moyens éventuels pour appliquer une différence de potentiel, entre la première extrémité (4) de la seconde ligne électriquement conductrice (2) et la seconde extrémité (6) de la seconde ligne électriquement conductrice (2), et les moyens éventuels pour appliquer une différence de potentiel, dite deuxième différence de potentiel de polarisation entre la deuxième zone (20)de la surface du nanofil (15)et la première zone (19) de la surface du nanofil (15)dans le sens de la longueur du nanofil sont constitués par un même deuxième générateur de tension.

6. Dispositif selon la revendication 4 ou 5, dans lequel ledit premier et ledit deuxième générateur de tension sont remplacés par un seul générateur de tension qui peut appliquer une différence de potentiel, entre la première extrémité (3) de la première ligne électriquement conductrice (1) et la seconde extrémité (5) de la première ligne électriquement conductrice (1) et une différence de potentiel, entre la première zone (19) de la surface du nanofil (15) et la deuxième zone (20) de la surface du nanofil (15), dans le sens de la longueur du nanofil, ou bien qui peut appliquer une différence de potentiel, entre la première extrémité (4) de la seconde ligne électriquement conductrice (2) et la seconde extrémité (6) de la seconde ligne électriquement conductrice (2), et une différence de potentiel, entre la deuxième zone (20) de la surface du nanofil et la première zone (19) de la surface du nanofil, dans le sens de la longueur du nanofil.

7. Dispositif selon l'une quelconque des revendications précédentes, qui comprend plusieurs premières bandes électriquement conductrices et secondes bandes électriquement conductrices.

8. Procédé pour former, sur au moins un nanofil en un semi-conducteur tel que le silicium, éventuellement dopé, un alliage de ce semi-conducteur avec un métal, par exemple choisi parmi le nickel et le platine, ou un métalloïde, ledit nanofil ayant par exemple une longueur de 0,5 à 10 µm et un diamètre de 20 à 50 nm, dans lequel on réalise les étapes successives suivantes :
a) on dépose ledit au moins un nanofil (15) en un semi-conducteur sur un substrat, par exemple une couche, en un matériau électriquement isolant, éventuellement disposé sur un autre substrat en un matériau différent dudit matériau électriquement isolant ;
b) on met en contact une première zone (19) de la surface du nanofil avec une partie centrale (17) d'une première bande électriquement conductrice (7), en un métal ou un métalloïde apte à former un alliage avec le semi-conducteur du nanofil, formant une partie rétrécie entre une première extrémité (3) et une seconde extrémité (5) d'une première ligne électriquement conductrice (1), et on met en contact une deuxième zone (20) de la surface du nanofil (15), espacée de la première zone (19) dans le sens de la longueur du nanofil avec une partie centrale (18) d'une seconde bande électriquement conductrice (8), en un métal ou un métalloïde apte à former un alliage avec le semi-conducteur du nanofil (15), formant une partie rétrécie entre une première extrémité (4) et une seconde extrémité (6) d'une seconde ligne électriquement conductrice (2) ;
c) on applique une différence de potentiel dite première différence de potentiel de polarisation entre la première zone (19) de la surface du nanofil et la deuxième zone (20) de la surface du nanofil (15), dans le sens de la longueur du nanofil ;
d) on applique une différence de potentiel dite première différence de potentiel de chauffage, entre la première extrémité (3) de la première ligne électriquement conductrice (1) et la seconde extrémité (5) de la première ligne électriquement conductrice (1), tout en maintenant constante la première différence de potentiel de polarisation, et on mesure simultanément une différence de potentiel, dite première différence de potentiel de fuite, de part et d'autre d'une résistance R en série avec le nanofil (15) située entre la seconde extrémité (6) de la seconde ligne électriquement conductrice et la terre ;
e) on augmente la première différence de potentiel de chauffage de manière continue ou par incrément, de manière manuelle ou automatique, généralement à partir d'une valeur voisine de zéro, jusqu'à ce que l'on observe un saut de la première différence de potentiel de fuite indiquant que la première différence de potentiel de chauffage est alors suffisante pour provoquer un échauffement de la partie centrale (17) de la première bande électriquement conductrice (7) et de la première zone (19) de la surface du nanofil, la diffusion du métal ou du métalloïde dans et le long du nanofil et la formation de l'alliage.

9. Procédé selon la revendication 8, dans lequel le substrat en un matériau électriquement isolant est une couche en silice éventuellement disposée sur un substrat en silicium fortement dopé ; un substrat, par exemple une couche en nitrure de silicium ; ou un substrat, par exemple une couche d'alumine.

10. Procédé selon l'une quelconque des revendications 8 à 9, dans lequel on dépose plusieurs nanofils sur le substrat en un matériau électriquement isolant, lesdits nanofils étant disposés de manière aléatoire, leur position étant éventuellement repérée à l'aide de marques préalablement réalisées sur le substrat ; ou selon des structures, motifs ordonnés, par exemple sous la forme de rangées ordonnées de nanofils.

11. Procédé selon l'une quelconque des revendications 8 à 10, dans lequel en fonction de la première différence de potentiel de fuite mesurée, on modifie la première différence de potentiel de chauffage.

12. Procédé selon l'une quelconque des revendications 8 à 11, dans lequel, à l'issue de l'étape e), on réalise les étapes f), g), h) suivantes :
f) on applique une différence de potentiel dite deuxième différence de potentiel de polarisation entre la deuxième zone (20) de la surface du nanofil et la première zone (19) de la surface du nanofil, dans le sens de la longueur du nanofil ;
g) on applique une différence de potentiel dite deuxième différence de potentiel de chauffage, entre la première extrémité (4) de la seconde ligne électriquement conductrice (2) et la seconde extrémité (6) de la seconde ligne électriquement conductrice (2), tout en maintenant constante la deuxième différence de potentiel de polarisation, et on mesure simultanément une différence de potentiel, dite deuxième différence de potentiel de fuite, de part et d'autre d'une résistance R' en série avec le nanofil (15) située entre la seconde extrémité (6) de la première ligne électriquement conductrice et la terre ;
h) on augmente la deuxième différence de potentiel de chauffage de manière continue ou par incrément, de manière manuelle ou automatique, généralement à partir d'une valeur généralement voisine de zéro, jusqu'à ce que l'on observe un saut de la deuxième différence de potentiel de fuite indiquant que la deuxième différence de potentiel de chauffage est alors suffisante pour provoquer un échauffement de la partie centrale (18) de la seconde bande électriquement conductrice (8) et de la deuxième zone (20) de la surface du nanofil, la diffusion du métal ou du métalloïde dans et le long du nanofil et la formation de l'alliage.

13. Procédé selon la revendication 12, dans lequel en fonction de la deuxième différence de potentiel de fuite mesurée, on modifie la deuxième différence de potentiel de chauffage.

14. Procédé selon l'une quelconque des revendications 11 et 13, dans lequel la première différence de potentiel de chauffage et/ou la deuxième différence de potentiel de chauffage est(sont) modifiée(s) afin d'obtenir une première portion en alliage et/ou une deuxième portion en alliage de longueur(s) déterminée(s) (32, 33) le long du nanofil (15, 31) à partir respectivement de la première zone (19, 34) de la surface du nanofil et de la deuxième zone (20, 35) de la surface du nanofil.

15. Procédé selon la revendication 14, dans lequel la portion en semi-conducteur (38) de la longueur du nanofil entre la première portion en alliage (32) et la deuxième portion en alliage (33) est le canal d'un transistor.

16. Procédé selon la revendication 15, dans lequel on établit une courbe d'étalonnage qui donne pour chaque valeur du (des) courant(s) de fuite la longueur (39) du canal du transistor et on règle le premier et/ou le deuxième potentiel de chauffage de manière à obtenir la longueur de canal souhaitée.

17. Procédé selon l'une quelconque ces revendications 8 à 16, dans lequel les bandes électriquement conductrices sont définies directement sur les nanofils, par exemple par un procédé de lithographie.

## Patentansprüche

1. Vorrichtung, die zum Herstellen auf einem Nanodraht aus einem Halbleiter (15) einer Legierung dieses Halbleiters mit einem Metall oder Halbmetall ausgelegt ist, wobei diese Vorrichtung Folgendes umfasst:
- einen ersten elektrisch leitenden Streifen (7) aus einem Metall oder Halbmetall, das eine Legierung mit dem Halbleiter des Nanodrahts (15) bilden kann, und einen zweiten elektrisch leitenden Streifen (8) aus einem Metall oder Halbmetall, das eine Legierung mit dem Halbleiter des Nanodrahts bilden kann, die von einander getrennt sind, wobei der erste (7) und zweite (8) elektrisch leitende Streifen zum Beispiel aus Nickel oder Platin, vorzugsweise parallel sind und einen bezüglich einer ersten elektrisch leitenden Leitung (1) und einer zweiten elektrisch leitenden Leitung (2) sich verengenden Abschnitt bilden, wobei die erste (1) und zweite (2) elektrisch leitende Leitung jeweils ein erstes Ende (3, 4) und ein zweites Ende (5, 6) umfasst und der mittlere Abschnitt (17) des ersten elektrisch leitenden Streifens (7) mit einer ersten Zone (19) der Oberfläche des Nanodrahts in Kontakt gebracht werden kann und der mittlere Abschnitt (18) des zweiten elektrisch leitfähigen Streifens (8) mit einer zweiten Zone (20) der Oberfläche des Nanodrahts, die von der ersten Zone (19) längsseitig entfernt ist, in Kontakt gebracht werden kann;
- Mittel (9, 10, 11) zum Anlegen einer Potentialdifferenz zwischen dem ersten Ende (3) der ersten elektrisch leitenden Leitung (1) und dem zweiten Ende (5) der ersten elektrisch leitenden Leitung (1) und Durchlassen eines Stroms vom ersten Ende (3) zum zweiten Ende (5) der ersten elektrisch leitenden Leitung (1), um eine Erwärmung des mittleren Teils (17) der ersten elektrisch leitenden Leitung (7) zu bewirken, und Mittel (14) zum Verbinden des zweiten Endes (6) der zweiten elektrisch leitenden Leitung (2) mit der Erde (13), wobei diese Mittel einen Widerstand R umfassen;
- gegebenenfalls Mittel zum Anlegen einer Potentialdifferenz zwischen dem ersten Ende (4) der zweiten elektrisch leitenden Leitung (2) und dem zweiten Ende (6) der zweiten elektrisch leitenden Leitung (2), wenn keine Potentialdifferenz zwischen dem ersten Ende (3) der ersten elektrisch leitenden Leitung (1) und dem zweiten Ende (5) der ersten elektrisch leitenden Leitung (1) angelegt ist, und Durchlassen eines Stroms vom ersten Ende (4) zum zweiten Ende (6) der zweiten elektrisch leitenden Leitung (2), und gegebenenfalls Mittel zum Verbinden des zweiten Endes (5) der ersten elektrisch leitenden Leitung (1) mit der Erde, wobei diese Mittel einen Widerstand R' umfassen;
- Mittel zum Messen einer erste Verlustpotentialdifferenz genannten Potential-differenz beiderseits des Widerstands R;
- gegebenenfalls Mittel zum Messen einer zweite Verlustpotentialdifferenz genannten Potentialdifferenz beiderseits des Widerstands R';
- Mittel zum Anlegen einer erste Polarisationspotentialdifferenz genannten Potentialdifferenz zwischen der ersten Zone (19) der Oberfläche des Nanodrahts und der zweiten Zone (20) der Oberfläche des Nanodrahts in Längsrichtung des Nanodrahts;
- gegebenenfalls Mittel zum Anlegen einer zweite Polarisationspotentialdifferenz genannten Potentialdifferenz zwischen der zweiten Zone (20) der Oberfläche des Nanodrahts und der ersten Zone (19) der Oberfläche des Nanodrahts (15) in Längsrichtung des Nanodrahts, wenn die erste Polarisationspotentialdifferenz nicht angelegt ist.

2. Vorrichtung gemäß Anspruch 1, bei der der erste (7) und zweite (8) elektrisch leitende Streifen jeweils eine Länge von 1 bis 5 µm, zum Beispiel 3 µm aufweist, und/oder der erste (7) und der zweite (8) elektrisch leitende Streifen100 nm bis 300 nm, zum Beispiel 200 nm bis 300 nm, von einander entfernt sind.

3. Vorrichtung gemäß einem der vorangehenden Ansprüche, bei der die Mittel (9, 10, 11) zum Anlegen einer Potentialdifferenz zwischen dem ersten Ende (3) der ersten elektrisch leitenden Leitung (1) und dem zweiten Ende (5) der elektrisch leitenden Leitung (1) und die allfälligen Mittel zum Anlegen einer Potentialdifferenz zwischen dem ersten Ende (4) der zweiten elektrisch leitenden Leitung (2) und dem zweiten Ende (6) der zweiten elektrischen Leitung (2) Mittel zum manuellen oder automatischen, kontinuierlichen oder schrittweisen Erhöhen oder Verringern dieser Potentialdifferenz(en), zum Beispiel als Funktion des Messwerts der ersten Verlustpotentialdifferenz beziehungsweise der zweiten Verlustpotentialdifferenz, umfassen.

4. Vorrichtung gemäß einem der vorangehenden Ansprüche, bei der sich die Mittel (9, 10, 11) zum Anlegen einer Potentialdifferenz zwischen dem ersten Ende (3) der ersten elektrisch leitenden Leitung (1) und dem zweiten Ende (5) der ersten elektrisch leitenden Leitung (1) und die Mittel zum Anlegen einer Polarisationspotentialdifferenz genannten Potentialdifferenz zwischen der ersten Zone (19) der Oberfläche des Nanodrahts (15) und der zweiten Zone (20) der Oberfläche des Nanodrahts (15) in Längsrichtung des Nanodrahts aus einem ersten selben Spannungsgenerator zusammensetzt.

5. Vorrichtung gemäß einem der vorangehenden Ansprüche, bei der sich die allfälligen Mittel zum Anlegen einer Potentialdifferenz zwischen dem ersten Ende (4) der zweiten elektrisch leitenden Leitung (2) und dem zweiten Ende (6) der zweiten elektrisch leitenden Leitung (2) und die allfälligen Mittel zum Anlegen einer zweite Polarisationspotentialdifferenz genannten Potentialdifferenz zwischen der zweiten Zone (20) der Oberfläche des Nanodrahts (15) und der ersten Zone (19) der Oberfläche des Nanodrahts (15) in Längsrichtung des Nanodrahts aus einem zweiten selben Spannungsgenerator zusammensetzt.

6. Vorrichtung gemäß Anspruch 4 oder 5, bei der dieser erste und dieser zweite Spannungsgenerator durch einen einzigen Spannungsgenerator ersetzt sind, der eine Potentialdifferenz zwischen dem ersten Ende (3) der ersten elektrisch leitenden Leitung (1) und dem zweiten Ende (5) der ersten elektrisch leitenden Leitung (1) und eine Potentialdifferenz zwischen der ersten Zone (19) der Oberfläche des Nanodrahts (15) und der zweiten Zone (20) der Oberfläche des Nanodrahts (15) in Längsrichtung des Nanodrahts anlegen kann oder auch eine Potentialdifferenz zwischen dem ersten Ende (4) der zweiten elektrisch leitenden Leitung (2) und dem zweiten Ende (6) der zweiten elektrisch leitenden Leitung (2) und eine Potentialdifferenz zwischen der zweiten Zone (20) der Oberfläche des Nanodrahts und der ersten Zone (19) der Oberfläche des Nanodrahts in Längsrichtung des Nanodrahts anlegen kann.

7. Vorrichtung gemäß einem der vorangehenden Ansprüche, die mehrere erste elektrisch leitende Streifen und zweite elektrisch leitende Streifen umfasst.

8. Verfahren zum Bilden auf wenigstens einem Nanodraht aus einem Halbleiter wie etwa gegebenenfalls dotiertem Silicium, einer Legierung dieses Halbleiters mit einem zum Beispiel aus Nickel und Platin ausgewählten Metall oder Halbmetall, wobei dieser Nanodraht zum Beispiel eine Länge von 0,5 bis 20 µm und einen Durchmesser von 20 bis 50 nm aufweist, bei dem die folgenden aufeinanderfolgenden Schritte durchgeführt werden:
a) der wenigstens eine Nanodraht (15) aus einem Halbleiter wird auf ein Substrat aufgebracht, zum Beispiel einer Schicht aus einem elektrisch isolierenden Material, das gegebenenfalls auf einem weiteren Substrat aus einem von dem elektrisch isolierenden Material verschiedenen Material aufgebracht ist,
b) eine erste Zone (19) der Oberfläche des Nanodrahts wird mit einem mittleren Abschnitt (17) eines ersten elektrisch leitenden Streifens (7) aus einem Metall oder einem Halbmetall, das eine Legierung mit dem Halbleiter des Nanodrahts bilden kann, in Kontakt gebracht, wobei zwischen einem ersten Ende (3) und einem zweiten Ende (5) einer ersten elektrisch leitenden Leitung (1) ein verengter Abschnitt gebildet wird und eine zweite Zone (20) der Oberfläche des Nanodrahts (15), die von der ersten Zone (19) in Längsrichtung des Nanodrahts entfernt ist, wird mit einem mittleren Abschnitt (18) eines zweiten elektrisch leitenden Streifens aus einem Metall oder einem Halbmetall, das eine Legierung mit dem Halbleiter des Nanodrahts (15) bilden kann, in Kontakt gebracht, wobei zwischen einem ersten Ende (4) und einem zweiten Ende (6) einer zweiten elektrisch leitenden Leitung (2) ein verengter Abschnitt gebildet wird;
c) eine erste Polarisationspotentialdifferenz genannte Potentialdifferenz wird zwischen der ersten Zone (19) der Oberfläche des Nanodrahts und der zweiten Zone (20) der Oberfläche des Nanodrahts (15) in Längsrichtung des Nanodrahts angelegt;
d) eine erste Erwärmungspotentialdifferenz genannte Potentialdifferenz wird zwischen dem ersten Ende (3) der ersten elektrisch leitenden Leitung (1) und dem zweiten Ende (5) der ersten elektrisch leitenden Leitung (1) angelegt, während die erste Polarisationspotentialdifferenz konstant gehalten wird, und gleichzeitig wird die erste Verlustpotentialdifferenz genannte Potentialdifferenz beiderseits eines zwischen dem zweiten Ende (6) der zweiten elektrisch leitenden Leitung und der Erde befindlichen Widerstands R in Reihe mit dem Nanodraht (15) gemessen;
e) die erste Erwärmungspotentialdifferenz wird so kontinuierlich oder schrittweise, manuell oder automatisch, im allgemeinen von einem Wert im allgemeinen nahe null erhöht, bis ein Anstieg der ersten Verlustpotentialdifferenz beobachtet wird, was anzeigt, dass die erste Erwärmungspotentialdifferenz dann zum Bewirken einer Erwärmung des mittleren Abschnitts (17) des ersten elektrisch leitenden Streifens (7) und der ersten Zone (19) der Oberfläche des Nanodrahts, der Diffusion des Metalls oder Halbmetalls in und entlang des Nanodrahts und der Legierungsbildung ausreichend ist.

9. Verfahren gemäß Anspruch 8, bei dem das Substrat aus einem elektrisch isolierenden Material eine Schicht aus auf gegebenenfalls stark dotiertem Silicium aufgebrachtem Siliciumoxid, ein Substrat wie zum Beispiel eine Schicht aus Silciumnitrid oder ein Substrat wie zum Beispiel eine Schicht aus Aluminiumoxid ist.

10. Verfahren gemäß einem der Ansprüche 8 bis 9, bei dem mehrere Nanodrähte auf das Substrat aus einem elektrisch isolierenden Material aufgebracht werden, wobei die Nanodrähte in zufälliger Weise aufgebracht werden und ihre Lage gegebenenfalls mit Hilfe zuvor auf dem Substrat angebrachter Markierungen oder Strukturen, geordneter Muster entsprechend wie zum Beispiel in Form geordneter Reihen von Nanodrähten festgelegt wurde.

11. Verfahren gemäß einem der Ansprüche 8 bis 10, bei dem als Funktion der ersten gemessenen Verlustpotentialdifferenz die erste Erwärmungspotentialdifferenz verändert wird.

12. Verfahren gemäß einem der Ansprüche 8 bis 11, bei dem am Ende von Schritt e) die folgenden Schritte f), g) und h) ausgeführt werden:
f) eine zweite, Polarisationspotentialdifferenz genannte Potentialdifferenz wird zwischen der zweiten Zone (20) der Oberfläche des Nanodrahts und der ersten Zone (19) der Oberfläche des Nanodrahts in Längsrichtung des Nanodrahts angelegt;
g) eine zweite, Erwärmungspotentialdifferenz genannte Potentialdifferenz wird zwischen dem ersten Ende (4) der zweiten elektrisch leitenden Leitung (2) und dem zweiten Ende (6) der zweiten elektrisch leitenden Leitung (2) angelegt, während die zweite Polarisationspotentialdifferenz konstant gehalten wird, und gleichzeitig wird eine zweite Verlustpotentialdifferenz genannte Potentialdifferenz auf beiden Seiten eines Widerstands R' in Reihe mit dem Nanodraht (15) zwischen dem zweiten Ende (6) der ersten elektrisch leitenden Leitung und der Erde gemessen;
h) die zweite Erwärmungspotentialdifferenz wird so kontinuierlich oder schrittweise, manuell oder automatisch, im allgemeinen von einem Wert im allgemeinen nahe null erhöht, bis ein Anstieg der zweiten Verlustpotentialdifferenz beobachtet wird, was anzeigt, dass die zweite Erwärmungspotentialdifferenz dann zum Bewirken einer Erwärmung des mittleren Abschnitts (18) des zweiten elektrisch leitenden Streifens (8) und der zweiten Zone (20) der Oberfläche des Nanodrahts, der Diffusion des Metalls oder Halbmetalls in und entlang des Nanodrahts und der Legierungsbildung ausreichend ist.

13. Verfahren gemäß Anspruch 12, bei dem als Funktion der zweiten gemessenen Verlustpotentialdifferenz die zweite Erwärmungspotentialdifferenz verändert wird.

14. Verfahren gemäß einem der Ansprüche 11 bis 13, bei dem die erste Erwärmungspotentialdifferenz und/oder zweite Erwärmungspotentialdifferenz zum Erhalten eines ersten Abschnitts aus Legierung und/oder eines zweiten Abschnitts aus Legierung mit vorbestimmter Länge (32, 33) längs des Nanodrahts (15, 31) von der ersten Zone (19, 34) der Oberfläche des Nanodrahts beziehungsweise der zweiten Zone (20, 35) der Oberfläche des Nanodrahts verändert wird (werden).

15. Verfahren gemäß Anspruch 14, bei dem der Anteil an Halbleiter (38) längs des Nanodrahts zwischen dem ersten Legierungsabschnitt (32) und dem zweiten Legierungsabschnitt (33) ein Transistorkanal ist.

16. Verfahren gemäß Anspruch 15, bei dem eine Eichkurve erstellt wird, die für jeden Wert des (der) Verluststroms (Verlustströme) die Länge (39) des Transistorkanals ergibt, und das erste und/oder zweite Erwärmungspotential so eingestellt wird, dass die gewünschte Länge des Kanals erhalten wird.

17. Verfahren gemäß einem der Ansprüche 8 bis 16, bei dem die elektrisch leitenden Streifen zum Beispiel durch ein lithographisches Verfahren direkt definiert werden.

## Claims

1. A device configured for forming on a nanowire made of a semiconductor (15), an alloy of said semiconductor with a metal or metalloid, said device comprising:
- a first electrically conducting strip (7) made of a metal or metalloid capable of forming an alloy with the semiconductor of the nanowire (15), and a second electrically conducting strip (8) made of a metal or metalloid capable of forming an alloy with the semiconductor of the nanowire, spaced apart from each other, the first (7) and the second (8) electrically conducting strips, for example made of nickel or of platinium, being preferably parallel and forming a narrowed portion of a first electrically conducting line (1) and of a second electrically conducting line (2), respectively, said first (1) and second (2) electrically conducting lines each comprising a first end (3, 4) and a second end (5, 6), the central portion (17) of the first electrically conducting strip (7) being able to be put into contact with a first area (19) of the surface of the nanowire and the central portion (18) of the second electrically conducting strip (8) being able to be put into contact with a second area (20) of the surface of the nanowire, spaced apart from the first area (19) in the direction of the length of the nanowire;
- means (9, 10, 11) for applying a potential difference, between the first end (3) of the first electrically conducting line (1) and the second end (5) of the first electrically conducting line (1) and for making a current pass from the first end (3) to the second end (5) of the first electrically conducting line (1) to cause heating up of the central portion (17) of the first electrically conducting strip (7), and means (14) for connecting the second end (6) of the second electrically conducting line (2) to the ground (13), said means comprising a resistor R;
- optionally, means for applying a potential difference, between the first end (4) of the second electrically conducting line (2) and the second end (6) of the second electrically conducting line (2) when no potential difference is applied between the first end (3) of the first electrically conducting line (1) and the second end (5) of the first electrically conducting line (1) and making a current pass from the first end (4) to the second end (6) of the second electrically conducting line (2), and optionally means for connecting the second end (5) of the first electrically conducting line (1) to the ground, said means comprising a resistor R';
- means for measuring a potential difference, said to be a first leakage potential difference on both sides of the resistor R;
- optionally, means for measuring a potential difference, said to be a second leakage potential difference on both sides of the resistor R';
- means for applying a potential difference, said to be a first bias potential difference between the first area (19) of the surface of the nanowire and the second area (20) of the surface of the nanowire, in the direction of the length of the nanowire;
- optionally, means for applying a potential difference, said to be a second bias potential difference between the second area (20) of the surface of the nanowire and the first area (19) of the surface of the nanowire (15), in the direction of the length of the nanowire when the first bias potential difference is not applied.

2. The device according to claim 1, wherein the first (7) and the second (8) electrically conducting strips each have a length from 1 to 5 pm, for example 3 µm, and/or the first (7) and the second (8) electrically conducting strips are spaced apart from each other by 100 nm to 300 nm, for example by 200 nm to 300 nm.

3. The device according to any one of the preceding claims, wherein the means (9, 10, 11) for applying a potential difference, between the first end (3) of the first electrically conducting line (1) and the second end (5) of the first electrically conducting line (1), and the optional means for applying a potential difference, between the first end (4) of the second electrically conducting line (2) and the second end (6) of the second electrically conducting line (2) include means for increasing or reducing this(these) potential difference(s) continuously or incrementally, either manually or automatically, for example according to the measured value of the first leakage potential difference, respectively of the second leakage potential difference.

4. The device according to any one of the preceding claims, wherein the means (9, 10, 11) for applying a potential difference, between the first end (3) of the first electrically conducting line (1) and the second end (5) of the first electrically conducting line (1) and the means for applying a potential difference, said to be a first bias potential difference between the first area (19) of the surface of the nanowire (15) and the second area (20) of the surface of the nanowire (15), in the direction of the length of the nanowire consist of a same first voltage generator.

5. The device according to any one of the preceding claims, wherein the optional means for applying a potential difference, between the first end (4) of the second electrically conducting line (2) and the second end (6) of the second electrically conducting line (2), and the optional means for applying a potential difference, said to be a second bias potential difference between the second area (20) of the surface of the nanowire (15) and the first area (19) of the surface of the nanowire (15) in the direction of the length of the nanowire consist of a same second voltage generator.

6. The device according to claim 4 or 5, wherein said first and said second voltage generators are replaced with a single voltage generator which may apply a potential difference, between the first end (3) of the first electrically conducting line (1) and the second end (5) of the first electrically conducting line (1) and a potential difference, between the first area (19) of the surface of the nanowire (15) and the second area (20) of the surface of the nanowire (15) in the direction of the length of the nanowire, or else which may apply a potential difference, between the first end (4) of the second electrically conducting line (2) and the second end (6) of the second electrically conducting line (2), and a potential difference, between the second area (20) of the surface of the nanowire and the first area (19) of the surface of the nanowire, in the direction of the length of the nanowire.

7. The device according to any one of the preceding claims, which comprises several first electrically conducting strips and second electrically conducting strips.

8. A method for forming on at least one nanowire made of a semiconductor, such as silicon, optionally doped silicon, an alloy of this semiconductor with a metal for example selected from nickel and platinum or a metalloid, said nanowires having for example a length from 0.5 to 10 µm and a diameter from 20 to 50 nm, wherein the following successive steps are carried out:
a) said at least one nanowire (15) made of a semiconductor is deposited on a substrate, for example a layer, made of an electrically insulating material, optionally positioned on another substrate made of a material different from said electrically insulating material;
b) a first area (19) of the surface of the nanowire is put into contact with a central portion (17) of a first electrically conducting strip (7), made of a metal or metalloid capable of forming an alloy with the semiconductor of the nanowire, forming a narrowed portion between a first end (3) and a second end (5) of a first electrically conducting line (1), and a second area (20) of the surface of the nanowire (15), spaced apart from the first area (19) in the direction of the length of the nanowire, is put into contact with a central portion (18) of a second electrically conducting strip (8), made of a metal or metalloid capable of forming an alloy with the semiconductor of the nanowire (15), forming a narrowed portion between a first end (4) and a second end (6) of a second electrically conducting line (2);
c) a potential difference said to be a first bias potential difference is applied between the first area (19) of the surface of the nanowire and the second area (20) of the surface of the nanowire (15), in the direction of the length of the nanowire;
d) a potential difference said to be a first heating potential difference is applied between the first end (3) of the first electrically conducting line (1) and the second end (5) of the first electrically conducting line (1), while maintaining constant the first bias potential difference, and a potential difference, said to be a first leakage potential difference is simultaneously measured on both sides of a resistor R in series with the nanowire (15), located between the second end (6) of the second electrically conducting line and ground;
e) the first heating potential difference is increased continuously or incrementally, either manually or automatically, generally from a value close to zero, until a jump in the first leakage potential difference is observed, indicating that the first heating potential difference is then sufficient for causing heating-up of the central portion (17) of the first electrically conducting strip (7) and of the first area (19) of the surface of the nanowire, diffusion of the metal or metalloid in and along the nanowire and formation of the alloy.

9. The method according to Claims 8, wherein the substrate made of an electrically insulating material is a silica layer optionally positioned on a substrate made of heavily doped silicon; a substrate, for example a layer, made of silicon nitride; or a substrate, for example a layer, made of alumina.

10. The method according to any one of claims 8 to 9, wherein several nanowires are deposited on the substrate made of an electrically insulating material, said nanowires being positioned randomly, their position being optionally marked with marks made beforehand on the substrate; or according to ordered structures, patterns, for example in the form of ordered rows of nanowires.

11. The method according to any one of claims 8 to 10, wherein according to the measured first leakage potential difference, the first heating potential difference is modified.

12. The method according to any one of claims 8 to 11, wherein, at the end of step e), the following steps f), g), h) are carried out:
f) a potential difference said to be a second bias potential difference is applied between the second area (20) of the surface of the nanowire and the first area (19) of the surface of the nanowire in the direction of the length of the nanowire;
g) a potential difference said to be a second heating potential difference is applied between the first end (4) of the second electrically conducting line (2) and the second end (6) of the second electrically conducting line (2), while maintaining constant the second bias potential difference, and a potential difference said to be a second leakage potential difference is simultaneously measured on both sides of a resistor R' in series with the nanowire (15), located between the second end (6) of the first electrically conducting line and ground;
h) the second heating potential difference is increased continuously or incrementally, either manually or automatically, generally from a value generally close to zero, until a jump in the second leakage potential difference is observed indicating that the second heating potential difference is then sufficient for causing heating-up of the central portion (18) of the second electrically conducting strip (8) and of the second area (20) of the surface of the nanowire, diffusion of the metal or metalloid in and along the nanowire and formation of the alloy.

13. The method according to claim 12, wherein, according to the measured second leakage potential difference, the second heating potential difference is modified.

14. The method according to any one of claims 11 and 13, wherein the first heating potential difference and/or the second heating potential difference is (are) modified in order to obtain a first portion made of an alloy and/or a second portion made of an alloy with determined length(s) (32, 33) along the nanowire (15, 31) from the first area (19, 34) of the surface of the nanowire and from the second area (20, 35) of the surface of the nanowire, respectively.

15. The method according to claim 14, wherein the portion made of semiconductor (38) of the length of the nanowire between the first portion made of an alloy (32) and the second portion made of an alloy (33) is the channel of a transistor.

16. The method according to claim 15, wherein a calibration curve is established which gives for each value of the leakage current(s), the length (39) of the channel of the transistor and the first and/or the second heating potential is (are) adjusted so as to obtain the desired channel length.

17. The method according to any one of claims 8 to 16, wherein the electrically conducting strips are defined directly on the nanowires, for example by a lithography process.
